# EUROPEAN PATENT APPLICATION

(11) **EP 4 676 199 A1**
(43) Date of publication of application: **07.01.2026**
(21) Application number: 25187073.9
(22) Date of filing: 02.07.2025
(51) Int. Cl.: H10K 59/121

(54) **DISPLAY PANEL AND ELECTRONIC DEVICE INCLUDING THE SAME**

(30) Priority: 03.07.2024 KR 20240087820; 15.07.2024 KR 20240093345
(71) Applicant: Samsung Display Co., Ltd., Yongin-si, Gyeonggi-do 17113 (KR)
(72) Inventor: Kim, Daehyun, 17113 Yongin-si (KR); Kim, Mihae, 17113 Yongin-si (KR); Yoon, Hyeonjun, 17113 Yongin-si (KR); Kim, Sunghwan, 17113 Yongin-si (KR); Shin, Heyjin, 17113 Yongin-si (KR); Yun, Huigyeong, 17113 Yongin-si (KR)
(74) Representative: Taor, Simon Edward William

(57) **Abstract**

A display panel includes a substrate, a pixel circuit layer disposed on the substrate and including a first pixel circuit, and a light-emitting diode electrically connected to the first pixel circuit, wherein the pixel circuit layer further includes a first conductive layer including a first conductive pattern disposed on the substrate, a second conductive layer disposed on the first conductive layer and including a second conductive pattern partially overlapping the first conductive pattern, and a first semiconductor layer disposed on the second conductive layer and including a first semiconductor pattern overlapping the second conductive pattern, wherein the first semiconductor pattern is conductive.

## Description

### CROSS-REFERENCE TO RELATED APPLICATIONS

This application claims priority to Korean Patent Application Nos. 10-2024-0087820, filed on July 3, 2024, and 10-2024-0093345, filed on July 15, 2024, in the Korean Intellectual Property Office.

### BACKGROUND

### 1. Technical Field

The disclosure relates to a display panel and an electronic device including the display panel.

### 2. Description of the Related Art

In recent years, the uses of display devices have become more diverse. As the range of use of display devices has expanded, the demand for high-resolution display devices has increased. In order to manufacture a high-resolution display device, it is desirable to arrange electronic elements of various configurations in a narrow area.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The technical objectives to be achieved by the disclosure are not limited to those described herein, and other technical objectives that are not mentioned herein may be clearly understood by a person skilled in the art from this disclosure.

One or more embodiments of the disclosure may include a display panel with improved display quality and an electronic device including the display panel. Embodiments of the disclosure set forth herein are examples, and the scope of the disclosure is not limited thereby.

Additional aspects will be set forth in part in the description which follows and, in part, will be apparent from the description, or may be learned by practice of the presented embodiments of the disclosure.

According to one or more embodiments, a display panel may include a substrate, a pixel circuit layer disposed on the substrate and including a first pixel circuit, and a light-emitting diode electrically connected to the first pixel circuit, wherein the pixel circuit layer further may include a first conductive layer including a first conductive pattern disposed on the substrate, a second conductive layer disposed on the first conductive layer and including a second conductive pattern partially overlapping the first conductive pattern, and a first semiconductor layer disposed on the second conductive layer and including a first semiconductor pattern overlapping the second conductive pattern, wherein the first semiconductor pattern may be conductive.

The first semiconductor layer may include an oxide semiconductor material.

A constant voltage may be applied to the first conductive pattern and the first semiconductor pattern.

The first pixel circuit may include a first transistor connected between a driving voltage line and the light-emitting diode, a storage capacitor connected between a first node to which a gate electrode of the first transistor is connected and a second node to which a first electrode of the first transistor is connected, and a hold capacitor connected to the second node.

The first semiconductor layer may further include a second semiconductor pattern and comprising a channel region of the first transistor, wherein the first semiconductor pattern and the second semiconductor pattern are disposed on a same layer, the first semiconductor pattern and the second semiconductor pattern may be disposed to be spaced apart from each other.

The hold capacitor may include a first sub-hold capacitor and a second sub-hold capacitor that overlap each other, the first sub-hold capacitor may comprise a portion of the second conductive pattern overlapping the first conductive pattern, and the second sub-hold capacitor may comprise a portion of the second conductive pattern overlapping the first semiconductor pattern.

The hold capacitor may be connected between the second node and the driving voltage line.

The first conductive pattern and the first semiconductor pattern may be electrically connected to the driving voltage line and receive a same driving voltage.

The first pixel circuit may further include a second transistor connected between a data line and the first node, and a third transistor connected between a reference voltage line and the first node.

The hold capacitor may be connected between the second node and the driving voltage line, and the first pixel circuit may further include an auxiliary hold capacitor connected between a lower gate electrode of the first transistor and the reference voltage line, the auxiliary hold capacitor may include a third sub-hold capacitor and a fourth sub-hold capacitor that overlap each other, the first conductive layer may further include a third conductive pattern disposed to be apart from the first conductive pattern, the first semiconductor layer may further include a third semiconductor pattern that is disposed to be apart from the first semiconductor pattern and is conductive, the third sub-hold capacitor may comprise a portion of the second conductive pattern overlapping the third conductive pattern, and the fourth sub-hold capacitor may comprise a portion of the second conductive pattern overlapping the third semiconductor pattern.

The first conductive layer may further include a fourth conductive pattern disposed on a same layer as the first conductive pattern and disposed to be apart from the first conductive pattern, wherein the second conductive pattern may extend and partially overlap the fourth conductive pattern.

The storage capacitor may include a first sub-storage capacitor and a second sub-storage capacitor, the first sub-storage capacitor may comprise a portion of the second conductive pattern overlapping the fourth conductive pattern, and the second sub-storage capacitor may comprise a portion of the second conductive pattern overlapping the first semiconductor pattern, and the first semiconductor pattern may be electrically connected to an electrode corresponding to the first node.

The first pixel circuit may further include a fourth transistor connected between the driving voltage line and the first transistor, the pixel circuit layer may further include a second semiconductor layer including a channel region of the fourth transistor, and the second semiconductor layer may be disposed between the substrate and the first conductive layer, and the second semiconductor layer may include a silicon semiconductor material.

According to one or more embodiments, an electronic device may include a display panel, and a lower cover forming an exterior and having an opening exposing a portion of the display panel to a front surface, wherein the display panel may include a substrate, a pixel circuit layer disposed on the substrate and including a first pixel circuit, and a light-emitting diode electrically connected to the first pixel circuit, wherein the pixel circuit layer further may include a first conductive layer including a first conductive pattern disposed on the substrate, a second conductive layer disposed on the first conductive layer and including a second conductive pattern partially overlapping the first conductive pattern, and a first semiconductor layer disposed on the second conductive layer and including a first semiconductor pattern overlapping the second conductive pattern, wherein the first semiconductor pattern is conductive.

The first semiconductor layer may include an oxide semiconductor material.

A constant voltage may be applied to the first conductive pattern and the first semiconductor pattern.

The first pixel circuit may include a first transistor connected between a driving voltage line and the light-emitting diode; a storage capacitor connected between a first node to which a gate electrode of the first transistor is connected and a second node to which a first electrode of the first transistor is connected; and a hold capacitor connected to the second node.

The hold capacitor may include a first sub-hold capacitor and a second sub-hold capacitor that overlap each other, the first sub-hold capacitor may include a portion of the second conductive pattern overlapping the first conductive pattern, and the second sub-hold capacitor may include a portion of the second conductive pattern overlapping the first semiconductor pattern.

The hold capacitor may be connected between the second node and the driving voltage line.

The first conductive pattern and the first semiconductor pattern may be electrically connected to the driving voltage line and receive a same driving voltage.

According to an aspect, there is provided a display device as set out in claim 1. Additional features are set out in claims 2 to 14. According to an aspect, there is provided an electronic device as set out in claim 15.

### BRIEF DESCRIPTION OF THE DRAWINGS

The above and other aspects, features, and advantages of the disclosure will be more apparent by describing in detail embodiments thereof with reference to the attached drawings, in which:
FIG. 1 is a schematic perspective view showing an electronic device according to an embodiment;
FIG. 2 is an exploded schematic perspective view showing an electronic device according to an embodiment;
FIG. 3 is a block diagram of an electronic device according to an embodiment;
FIG. 4 is a schematic plan view illustrating a display panel according to an embodiment.
FIG. 5 is a schematic side view illustrating a display panel according to an embodiment;
FIG. 6 is a schematic plan view showing a display panel according to an embodiment;
FIGS. 7A and 7B are enlarged schematic plan views of an area VII of FIG. 6, which is a portion of the display panel according to an embodiment;
FIG. 8 is a schematic diagram of an equivalent circuit of a light-emitting diode and a pixel circuit of a display panel according to an embodiment;
FIG. 9 is a schematic plan view illustrating pixel circuits of a display panel according to an embodiment;
FIGS. 10 to 18 are schematic plan views according to a process of forming a pixel circuit of a display panel according to an embodiment;
FIG. 19 is an enlarged schematic plan view of an area B of FIG. 9, which is a portion of the display panel according to an embodiment;
FIG. 20 is a schematic cross-sectional view of the display panel along line I-I' of FIG. 19 according to an embodiment;
FIG. 21 is a schematic diagram of an equivalent circuit of a light-emitting diode and a pixel circuit of a display panel according to another embodiment;
FIG. 22 is a schematic cross-sectional view of a display panel according to another embodiment;
FIG. 23 is a schematic diagram of an equivalent circuit of a light-emitting diode and a pixel circuit of a display panel according to another embodiment;
FIG. 24 is a schematic cross-sectional view of a display panel according to another embodiment; and
FIG. 25 is a schematic cross-sectional view of a display panel according to another embodiment.

### DETAILED DESCRIPTION OF THE EMBODIMENTS

The disclosure will now be described more fully hereinafter with reference to the accompanying drawings, in which embodiments are shown. This disclosure may, however, be embodied in different forms and should not be construed as limited to the embodiments set forth herein. Rather, these embodiments are provided so that this disclosure will be thorough and complete, and will fully convey the scope of the disclosure to those skilled in the art.

In the drawings, sizes, thicknesses, ratios, and dimensions of the elements may be exaggerated for ease of description and for clarity. Like numbers and/or reference characters refer to like elements throughout.

As used herein, the singular forms, "a," "an," and "the" are intended to include the plural forms as well, unless the context clearly indicates otherwise.

In the specification and claims, the term "and/or" is intended to include any combination of the terms "and" and "or" for the purpose of its meaning and interpretation. For example, "A and/or B" may be understood to mean "A, B, or A and B." The terms "and" and "or" may be used in the conjunctive or disjunctive sense and may be understood to be equivalent to "and/or."

In the specification and the claims, the phrase "at least one of" is intended to include the meaning of "at least one selected from the group of" for the purpose of its meaning and interpretation. For example, "at least one of A and B" may be understood to mean "A, B, or A and B." In another example, the expression "at least one of A, B or C" may be understood to mean "A, B, C, A and B, A and C, B and C, A and B and C," or variations thereof.

The disclosure is subject to various modifications and may have many embodiments, some of which are illustrated in the drawings and further described in the description. The advantages and features of the disclosure, and methods of achieving them will become readily apparent with reference to the embodiments described below in detail together with the accompanying drawings. However, the disclosure is not limited to the embodiments described herein and may be implemented in various forms.

Hereinafter, embodiments will be described in detail with reference to the accompanying drawings, and when being described with reference to the drawings, the same or corresponding components are given the same reference numerals, and duplicate descriptions thereof will be omitted.

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the disclosure.

The spatially relative terms "below", "beneath", "lower", "above", "upper", or the like, may be used herein for ease of description to describe the relations between one element or component and another element or component as illustrated in the drawings. It will be understood that the spatially relative terms are intended to encompass different orientations of the device in use or operation, in addition to the orientation depicted in the drawings. For example, in the case where a device illustrated in the drawing is turned over, the device positioned "below" or "beneath" another device may be placed "above" another device. Accordingly, the illustrative term "below" may include both the lower and upper positions. The device may also be oriented in other directions and thus the spatially relative terms may be interpreted differently depending on the orientations.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

The terms "face" and "facing" mean that a first element may directly or indirectly oppose a second element. In a case in which a third element intervenes between the first and second element, the first and second element may be understood as being indirectly opposed to one another, although still facing each other.

The terms "comprises," "comprising," "includes," and/or "including," "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

The phrase "in a schematic plan view" means viewing the object from the top, and the phrase "in a schematic cross-sectional view" means viewing a cross-section of which the object is vertically cut from the side. Hence, the expression "in a schematic plan view" used herein may mean that an object is viewed in a third direction "z" from the top. The phrase "in a schematic cross-sectional view" means viewing a cross-section in a first direction "x" or a second direction "y" of which the object is vertically cut from the side. The third direction "z" also may be referred to as the "thickness direction".

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the disclosure pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Embodiments may be described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies.

In the case of the blocks, units, and/or modules being implemented by microprocessors or other similar hardware, they may be programmed and controlled using software (for example, microcode) to perform various functions discussed herein and may optionally be driven by firmware and/or software.

It is also contemplated that each block, unit, and/or module may be implemented by dedicated hardware, or as a combination of dedicated hardware to perform some functions and a processor (for example, one or more programmed microprocessors and associated circuitry) to perform other functions.

Each block, unit, and/or module of embodiments may be physically separated into two or more interacting and discrete blocks, units, and/or modules without departing from the scope of the disclosure.

Further, the blocks, units, and/or modules of embodiments may be physically combined into more complex blocks, units, and/or modules without departing from the scope of the disclosure.

In the following embodiments, the terms including or that has, etc. are intended to imply the presence of the recited features or components and do not preclude the possibility of the addition of one or more other features or components.

In the following embodiments, when a portion of a film, area, component, etc. is to be over or on top of another portion, this includes not only when it is directly on top of the other portion, but also when there are other films, areas, components, etc. disposed therebetween.

In the drawings, components may be exaggerated or reduced in size for ease of illustration. For example, the size and thickness of each configuration shown in the drawings are arbitrary for purposes of illustration and the disclosure is not necessarily limited to those shown.

In some embodiments, a particular sequence of processes may be performed in a different order than that described. For example, two processes described in succession may be performed substantially simultaneously, or may be performed in the opposite order from the order described.

It will be understood that when an element (or a region, a layer, a portion, or the like) is referred to as "being on", "disposed on", "connected to" or "coupled to" another element in the specification, it can be directly disposed on, connected or coupled to another element mentioned above, or intervening elements may be disposed therebetween. It will be understood that the terms "connected to" or "coupled to" may include a physical or electrical connection or coupling. In case that an element is referred to as being "in contact" or "contacted" or the like to another element, the element may be in "electrical contact" or in "physical contact" with another element; or in "indirect contact" or in "direct contact" with another element.

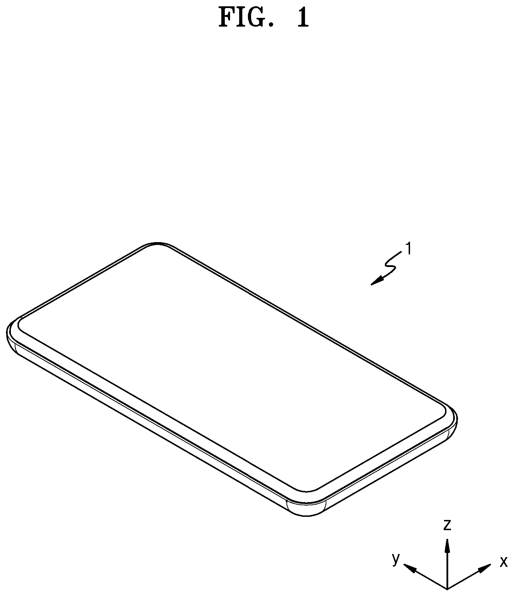

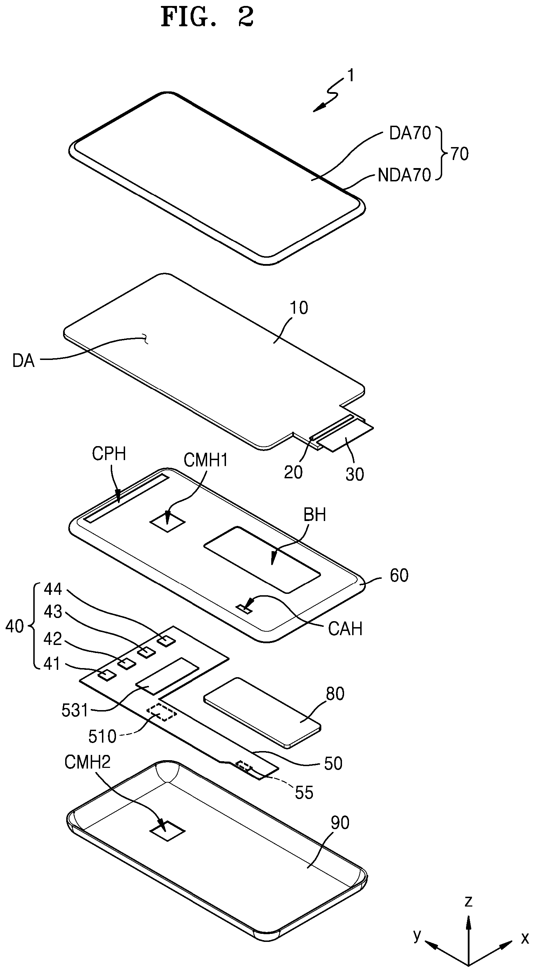

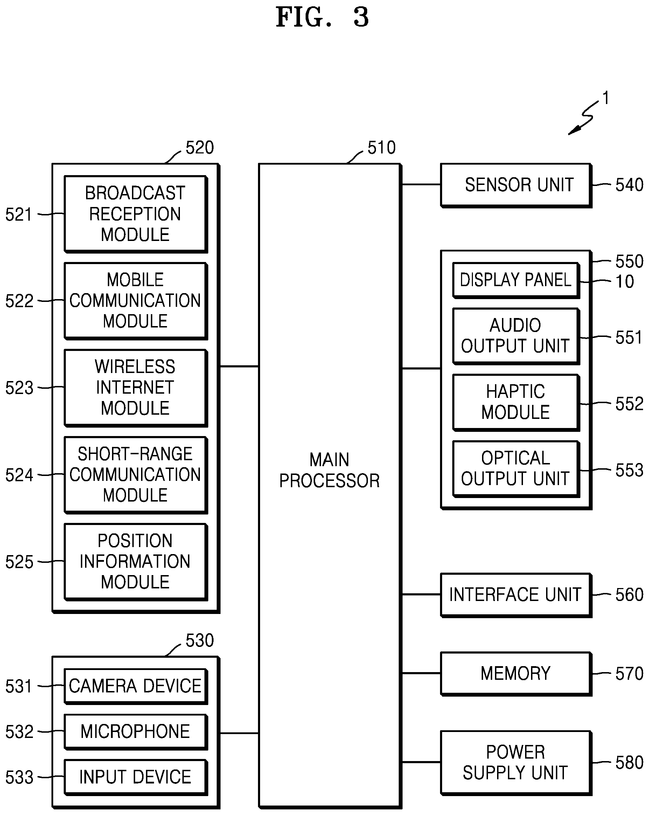

FIG. 1 is a schematic perspective view of an electronic device 1 according to an embodiment, FIG. 2 is an exploded schematic perspective view of the electronic device 1 according to an embodiment, and FIG. 3 is a block diagram of the electronic device 1 according to an embodiment.

Referring to FIG. 1 and FIG. 2, the electronic device 1 according to an embodiment may be a device that displays a moving image or a still image, and may be used as a display screen for various products, such as a television, a laptop, a monitor, a billboard, and an Internet of things (IOT), as well as portable electronic devices, such as a mobile phone, a smart phone, a tablet personal computer (PC), a mobile communication terminal, an electronic notebook, an electronic book, a portable multimedia player (PMP), a navigation system, and an ultra-mobile PC (UMPC). Also, the electronic device 1 according to an embodiment may be used in a wearable device, such as a smart watch, a watch phone, a glasses-type display, or a head mounted display (HMD). The electronic device 1 according to an embodiment may be used as a center information display (CID) placed on a center fascia or dashboard of a car, a room mirror display replacing a side mirror of a car, or a display placed on the back of a front seat as entertainment for the rear seat of a car.

In FIGS. 1 and 2, for convenience of description, the electronic device 1 according to an embodiment is illustrated as being used as a smart phone. The electronic device 1 according to an embodiment may include a cover window 70, a display panel 10, a data driver 20, a display circuit board 30, a component 40, a bracket 60, a main circuit board 50, a battery 80, and a lower cover 90, or a combination thereof.

In a schematic plan view of the specification and/or drawings, "left", "right", "up", and "down" refer to the orientation of the display panel 10 when viewed in a vertical direction of the display panel 10. For example, "left" refers to the negative first direction (e.g., the negative x-axis direction), "right" refers to the positive first direction (e.g., the x-axis direction), "up" refers to the positive second direction (e.g., the y-axis direction), and "down" refers to the negative second direction (e.g., the negative y-axis direction).

The electronic device 1 may be formed to have a rectangular shape in a schematic plan view. For example, as shown in FIG. 1, the electronic device 1 may have a rectangular planar shape having a short side in the first direction (e.g., the x-axis direction) and a long side in the second direction (e.g., the y-axis direction). A corner where the short side in the first direction (e.g., the x-axis direction) and the long side in the second direction (e.g., the y-axis direction) meet may be formed round with a certain curvature or at a right angle. The planar shape of the electronic device 1 is not limited to a rectangle, and may be another polygonal, oval, or irregular shape.

The cover window 70 may be placed above the display panel 10 to cover an upper surface of the display panel 10. Accordingly, the cover window 70 may have a function of protecting the upper surface of the display panel 10.

The cover window 70 may include a transmissive cover portion DA70 corresponding to the display panel 10 and a light-blocking cover portion NDA70 surrounding the transmissive cover portion DA70. The light-blocking cover portion NDA70 may include an opaque material (e.g., a colored opaque material) that blocks light. The light-blocking cover portion NDA70 may include a pattern that may be shown to a user when an image is not displayed.

The display panel 10 may be disposed below the cover window 70. The display panel 10 may overlap the transmissive cover portion DA70 of the cover window 70.

The display panel 10 may include a display area DA. The display area DA may be an area where an image is displayed and may include an area (hereinafter, component area) that transmits light emitted from the component 40 disposed below the display panel 10. The component 40 may include a sensor or camera that uses visible light, infrared rays, or sound.

The display panel 10 may be a light-emitting display panel that may include a light-emitting diode. The light-emitting diode may include an organic light-emitting diode including an organic light-emitting layer. In some embodiments, the light-emitting diode may be an inorganic light-emitting diode that may include an inorganic material. The inorganic light-emitting diode may include a PN junction diode that may include inorganic semiconductor-based materials. In case that a voltage is applied to the PN junction diode in a forward direction, holes and electrons may be injected, and energy generated by the recombination of the holes and electrons may be converted into light energy to emit light of a certain color. The aforementioned inorganic light-emitting diode may have a width of several to several hundred micrometers, and in some embodiments, the inorganic light-emitting diode may be referred to as a micro light-emitting diode (LED).

The display panel 10 may be a rigid display panel that is rigid and does not bend readily, or a flexible display panel that is flexible and may be readily bent, folded, or rolled. For example, the display panel 10 may be a foldable display panel that may be folded and unfolded, a curved display panel with a curved display surface, a bent display panel with an area other than the display surface bent, a rollable display panel that may be rolled or unfolded, and a stretchable display panel that may be stretched.

The display panel 10 may be a transparent display panel that is implemented to be transparent so that an object or background placed on the lower surface of the display panel 10 may be viewed from the upper surface of the display panel 10. In another example, the display panel 10 may be a reflective display panel capable of reflecting an object or background on the upper surface of the display panel 10.

The data driver 20 may be disposed on the display panel 10 in the form of an integrated circuit (IC). In another embodiment, the data driver 20 may be disposed on the display circuit board 30.

The display circuit board 30 may be attached to one side of the display panel 10. The display circuit board 30 may be a flexible printed circuit board (FPCB) that may bend, a rigid printed circuit board (PCB) that is hard and does not bend readily, or a composite printed circuit board including both a rigid PCB and a FPCB.

In an embodiment, a touch sensor driver may be disposed on the display circuit board 30. The touch sensor driver may be formed as an IC. The touch sensor driver may be attached to the display circuit board 30. The touch sensor driver may be electrically connected to touch electrodes of a touch screen layer of the display panel 10 through the display circuit board 30.

The touch screen layer of the display panel 10 may detect the user's touch input by using at least one of various touch methods, such as a resistive film method and an electrostatic capacitance method. For example, in case that the touch screen layer of the display panel 10 detects the user's touch input by an electrostatic capacitance method, the touch sensor driver may determine whether the user touches by applying driving signals to the driving electrodes among the touch electrodes and detecting voltages charged in the mutual capacitance between the driving electrodes and the sensing electrodes through the sensing electrodes among the touch electrodes. The user's touch may include a contact touch and/or a proximity touch. The contact touch refers to a direct contact of a user's finger or an object such as a pen with the cover window 70 placed on the touch screen layer. The proximity touch refers to a situation where a user's finger or an object such as a pen may be positioned close to the cover window 70, such as hovering. The touch sensor driver may transmit sensor data to a main processor 510 according to the detected voltages, and the main processor 510 may calculate touch coordinates where a touch input occurred by analyzing the sensor data.

A controller for supplying driving voltages for driving pixels of the display panel 10, a gate driver, and the data driver 20 may be disposed on the display circuit board 30.

The bracket 60 for supporting the display panel 10 may be arranged below the display panel 10. The bracket 60 may include plastic, metal, or both plastic and metal. A first camera hole CMH1 into which a camera device 531 may be inserted, a battery hole BH in which a battery 80 may be placed, and a cable hole CAH through which a cable connected to the display circuit board 30 may pass may be formed in the bracket 60. The bracket 60 may have a component hole CPH that overlaps the display panel 10. The component hole CPH may overlap the component 40 of the main circuit board 50 in a third direction (e.g., the z-axis direction). In an embodiment, the display area DA of the display panel 10 may overlap the component 40 of the main circuit board 50 in the third direction (e.g., the z-axis direction). In another embodiment, the bracket 60 may not be formed with a component hole CPH.

In an embodiment, the component 40 may include first to fourth components 41, 42, 43, and 44) that overlap and face the display panel 10 in a third direction (e.g., the z-axis direction). The first to fourth components 41, 42, 43, and 44 may include a proximity sensor, an illumination sensor, an iris sensor, a facial recognition sensor, and a camera (or an image sensor), respectively or a combination thereof. The proximity sensor using infrared rays may detect an object placed close to the upper surface of the electronic device 1, and the illumination sensor may detect the brightness of light incident on the upper surface of the electronic device 1. The iris sensor may photograph the iris of a person placed on the upper surface of the electronic device 1, and the camera may photograph an object placed on the upper surface of the electronic device 1. The component 40 is not limited to the proximity sensor, the illumination sensor, the iris sensor, the facial recognition sensor, and the camera, and various sensors described below may be placed.

The main circuit board 50 and the battery 80 may be placed below the bracket 60. The main circuit board 50 may be a PCB or an FPCB.

The main circuit board 50 may include the main processor 510, the camera device 531, a main connector 55, and the component 40, or a combination thereof. The main processor 510 may be formed as an IC. The camera device 531 may be arranged on both the upper surface and the lower surface of the main circuit board 50, and each of the main processor 510 and the main connector 55 may be arranged on one of the upper surface and the lower surface of the main circuit board 50.

The main processor 510 may control all functions of the electronic device 1. For example, the main processor 510 may output digital video data to the data driver 20 through the display circuit board 30 so that the display panel 10 may display an image. The main processor 510 may receive sensing data from the touch sensor driver. The main processor 510 may determine whether the user touches based on the sensing data and may execute an operation corresponding to the user's direct touch or proximity touch. The main processor 510 may be an application processor, a central processing unit, or a system chip, formed of an IC.

The camera device 531 may process an image frame, such as a still image or a moving image, obtained by an image sensor in a camera mode and may output the processed image frame to the main processor 510. The camera device 531 may include at least one of a camera sensor (e.g., a charge-coupled device (CCD), a complementary metal-oxide semiconductor (CMOS), etc.), a photo sensor (or an image sensor), and a laser sensor, or a combination thereof. The camera device 531 may be connected to an image sensor among the components 40 overlapping the display area DA and may process an image input to the image sensor.

The main connector 55 may be connected to the cable 35 passing through the cable hole CAH of the bracket 60, and thus, the main circuit board 50 may be electrically connected to the display circuit board 30.

In addition to the main processor 510, the camera device 531, and the main connector 55, the main circuit board 50 may further include a wireless communication unit 520, an input unit 530, a sensor unit 540, an output unit 550, an interface unit 560, a memory 570, and/or a power supply unit 580, shown in FIG. 3.

The wireless communication unit 520 may include at least one of a broadcast reception module 521, a mobile communication module 522, a wireless Internet module 523, a short-range communication module 524, and a location information module 525, or a combination thereof.

The broadcast reception module 521 may receive broadcast signals and/or broadcast-related information from an external broadcast management server through a broadcast channel. The broadcast channel may include a satellite channel or a terrestrial channel.

The mobile communication module 522 may transmit and receive a wireless signal with at least one of a base station, an external terminal, and/or a server on a mobile communication network constructed according to technical standards or communication methods for mobile communication (e.g., global system for mobile communication (GSM), code division multi access (CDMA), code division multi access 2000 (CDMA2000), enhanced voice-data optimized or enhanced voice-data only (EV-DO), wideband CDMA (WCDMA), high speed downlink packet access (HSDPA), high speed uplink packet access (HSUPA), long term evolution (LTE), and long term evolution-advanced (LTE-A)). The wireless signal may include various types of data according to voice call signals, video call signals, or text/multimedia message transmission and reception, or a combination thereof.

The wireless Internet module 523 refers to a module for wireless Internet access. The wireless Internet module 523 may transmit and receive wireless signals in a communication network according to wireless Internet technologies. Example wireless Internet technologies may include, for example, wireless LAN (WLAN), wireless-fidelity (Wi-Fi), Wi-Fi direct, digital living network alliance (DLNA), etc.

The short-range communication module 524 may be used for short-range communication and may support short-range communication by using at least one of Bluetooth^{™}, radio frequency identification (RFID), infrared data association (IrDA), ultra wideband (UWB), ZigBee, near field communication (NFC), Wi-Fi, Wi-Fi direct, and/or wireless universal serial bus (USB) technologies. The short-range communication module 524 may support, via a short-range wireless area network, wireless communication between the electronic device 1 and a wireless communication system, between the electronic device 1 and another electronic device, or between the electronic device 1 and a network where another electronic device (or an external server) is located. The short-range wireless communication network may be a short-range wireless personal area network. Another electronic device may be a wearable device capable of exchanging data (or capable of interoperating) with the electronic device 1.

The location information module 525 may be a module for obtaining the location (or current location) of the electronic device 1, and may include a global positioning system (GPS) module and/or a WiFi module.

The input unit 530 may include an image input unit such as the camera device 531 for inputting an image signal, an audio input unit such as a microphone 532 for inputting an audio signal, and an input device 533 for receiving information from a user, or a combination thereof.

The camera device 531 may process an image frame, such as a still image or a moving image, obtained by an image sensor in a video call mode or a shooting mode. The processed image frame may be displayed on the display panel 10 or stored in the memory 570.

The microphone 532 may process an external audio signal into electrical voice data. The processed voice data may be utilized in various ways depending on the function being performed (or the application being executed) in the electronic device 1.

The main processor 510 may control the operation of the electronic device 1 to correspond to information input through the input device 533. The input device 533 may include a mechanical input unit or a touch input unit, such as a button, a dome switch, a jog wheel, or a jog switch, located on the rear or side of the electronic device 1. The touch input unit may be formed by a touch screen layer of the display panel 10.

The sensor unit 540 may include one or more sensors that sense at least one of information within the electronic device 1, information describing the surrounding environment surrounding the electronic device 1, and user information and generate a sensing signal corresponding to the sensed information. The main processor 510 may control the driving or operation of the electronic device 1 or perform data processing, functions, or operations related to an application installed in the electronic device 1 based on the sensing signal. The sensor unit 540 may include at least one of a proximity sensor, an illumination sensor, an acceleration sensor, a magnetic sensor, a G-sensor, a gyroscope sensor, a motion sensor, an RGB sensor, an infrared (IR) sensor, a fingerprint recognition (or finger scan) sensor, an ultrasonic sensor, an optical sensor, a battery gauge, an environmental sensor (e.g., a barometer, a hygrometer, a thermometer, a radiation detection sensor, a heat detection sensor, a gas detection sensor, etc.), and a chemical sensor (e.g., an electronic nose, a healthcare sensor, a biometric sensor, etc.), or a combination thereof.

The output unit 550 may generate an output related to vision, hearing, or tactile sensations, and may include at least one of a display panel 10, an audio output unit 551, a haptic module 552, and an optical output unit 553 , or a combination thereof.

The display panel 10 may display (may output) information processed in the electronic device 1. For example, the display panel 10 may display information on an execution screen of an application running on the electronic device 1, or user interface (UI) or graphical user interface (GUI) information according to the execution screen information. The display panel 10 may include a display layer that displays an image and a touch screen layer that detects a user's touch input. Therefore, the display panel 10 may function as one of the input devices 533 that provide an input interface between the electronic device 1 and the user, and may function as one of the output units 550 that provide an output interface between the electronic device 1 and the user.

The audio output unit 551 may output audio data received from the wireless communication unit 520 or stored in the memory 570 in a call signal reception mode, a call mode, a recording mode, a voice recognition mode, a broadcast reception mode, etc. The audio output unit 551 also may output audio signals related to functions (e.g., a call signal reception sound, a message reception sound, etc.) performed in the electronic device 1. The audio output unit 551 may include a receiver and a speaker. At least one of the receiver and the speaker may be a sound generating device attached to a lower part of the display panel 10 to vibrate the display panel 10 and output sound. The sound generating device may be a piezoelectric element or piezoelectric actuator that contracts and expands according to an electric signal, or an exciter that vibrates the display panel 10 by generating magnetic force using a voice coil.

The haptic module 552 may generate various tactile effects that the user may feel or sense. The haptic module 552 may provide vibration to the user as a tactile effect. The haptic module 552 may deliver a tactile effect through direct contact, and also may be implemented so that the user may feel or sense the tactile effect through the muscle sense of the fingers or arms.

The optical output unit 553 may output a signal to notify the occurrence of an event using light from a light source. Examples of events occurring in the electronic device 1 may include message reception, call signal reception, missed call, alarm, schedule notification, email reception, and information reception through an application, or a combination thereof. The optical output unit 553 may output a signal, which is implemented (or realized) by the electronic device 1 that emits light of a single color or multiple colors from the front or back. The signal output may be terminated in case that electronic device 1 detects the user's event confirmation.

The interface unit 560 may function as a passage for various types of external devices electrically connected to the electronic device 1. The interface unit 560 may include at least one of a wired/wireless headset port, an external charger port, a wired/wireless data port, a memory card port, a port for electrically connecting a device equipped with an identification module, an audio input/output (I/O) port, a video I/O port, and an earphone port, or a combination thereof. In case that an external device is electrically connected to the interface unit 560, the electronic device 1 may perform appropriate control related to the connected external device in response to the electrical connection.

The memory 570 may store data supporting various functions of the electronic device 1. The memory 570 may store applications (application programs) running on the electronic device 1, data for the operation of the electronic device 1, and instructions. At least some of the applications may be downloaded from an external server via wireless communication. The memory 570 may store applications for the operation of the main processor 510, and may also temporarily store input/output data, such as a phone book, a message, a still image, and a moving image. The memory 570 may store haptic data for various patterns of vibration provided to the haptic module 552 and audio data regarding various sounds provided to the audio output unit 551. The memory 570 may include at least one type of storage medium selected from among a flash memory type, hard disk type, solid state disk (SSD) type), silicon disk drive (SDD) type, multimedia card micro type, or card type memory (e.g., a secure digital (SD) or extreme digital (XD) memory), a random access memory (RAM), a static random access memory (SRAM), a read-only memory (ROM), an electrically erasable programmable read-only memory (EEPROM), a programmable read-only memory (PROM), a magnetic memory, a magnetic disk, and an optical disk, or a combination thereof.

The power supply unit 580 may receive external power and internal power under the control of the main processor 510 and may supply power to each of the components included in the electronic device 1. The power supply unit 580 may include the battery 80. The power supply unit 580 may include a connection port, and the connection port may be configured as an example of the interface unit 560 to which an external charger that supplies power for charging a battery is electrically connected. In another example, the power supply unit 580 may charge the battery 80 wirelessly without using a connection port. The battery 80 may be arranged so as not to overlap the main circuit board 50 in the third direction (e.g., the z-axis direction). The battery 80 may overlap the battery hole BH of the bracket 60.

The lower cover 90 may be arranged below the main circuit board 50 and the battery 80. The lower cover 90 may be fastened and fixed to the bracket 60. The lower cover 90 may form a lower exterior of the electronic device 1. The lower cover 90 may include plastic, metal, or both plastic and metal.

A second camera hole CMH2 that exposes the lower surface of the camera device 531 may be formed in the lower cover 90. The position of the camera device 531 and the positions of the first and second camera holes CMH1 and CMH2 corresponding to the camera device 531 are not limited to the embodiments illustrated in FIGS. 1 and 2 and may be variously changed.

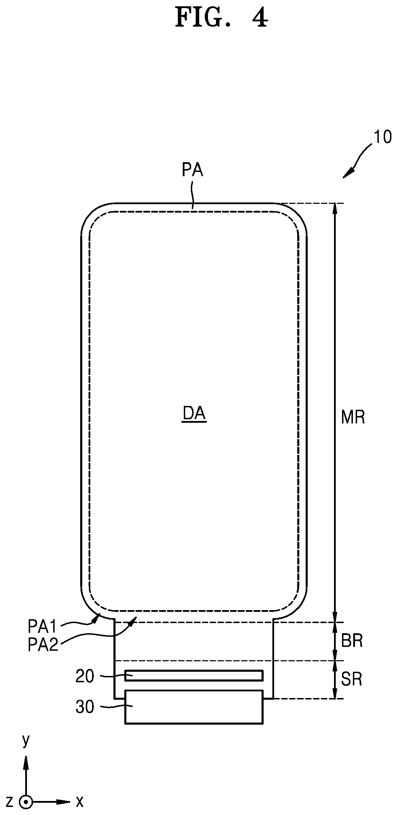

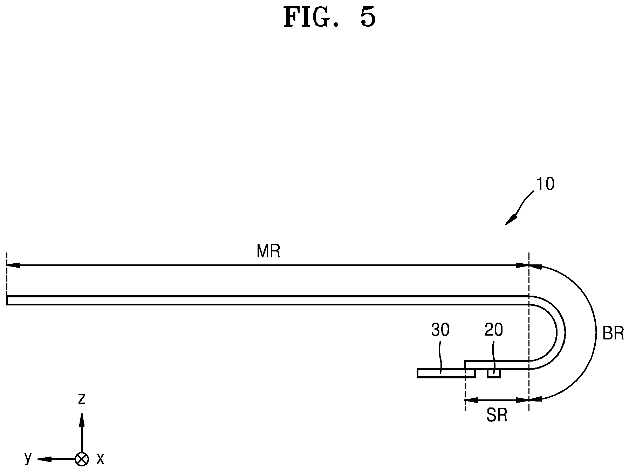

FIG. 4 is a schematic plan view illustrating a display panel 10 according to an embodiment, and FIG. 5 is a schematic side view illustrating a display panel 10 according to an embodiment.

The display panel 10 may include a display area DA and a peripheral area PA outside the display area DA. The display area DA may display an image, and pixels may be arranged in the display area DA. The display area DA may have various shapes, such as a circle, an oval, a polygon, or a certain geometric shape. For example, FIG. 4 illustrates that the display area DA has a roughly rectangular shape with round corners.

The peripheral area PA may be arranged on the outside of the display area DA. The peripheral area PA may include a first peripheral area PA1 arranged to surround at least a portion of the display area DA and a second peripheral area PA2 adjacent to one side of the display area DA and extending in a second direction (e.g., the negative second direction (e.g., the negative y-axis direction)). The width of the second peripheral area PA2 in a first direction (e.g., the x-axis direction) may be less than the width of the display area DA. This structure may facilitate bending of at least a portion of the second peripheral area PA2.

The plane of the display panel 10 illustrated in FIG. 4 may have substantially a same shape as a substrate 100 included in the display panel 10. The fact that the display panel 10 may include the display area DA and the peripheral area PA outside the display area DA may indicate that the substrate 100 may include the display area DA and the peripheral area PA outside the display area DA. Hereinafter, for convenience, the substrate 100 is described as having the display area DA and the peripheral area PA.

The display panel 10 may include a main area MR, a bending area BR outside the main area MR, and a sub-area SR spaced apart from the main area MR with the bending area BR between the sub-area SR and the main area MR. The main area MR may be arranged on a side of the bending area BR, and the sub-area SR may be arranged on another side of the bending area BR. The display panel 10 may be bent in the bending area BR, as illustrated in FIG. 5, and at least a portion of the sub-area SR may overlap the main area MR when viewed in the third direction (e.g., the z-axis direction). Although FIG. 5 illustrates that the display panel 10 is bent, embodiments of the disclosure are not limited thereto. In another embodiment, the display panel 10 may be a foldable display panel, and the display area DA may be bent around a bending axis crossing the display area DA. In another embodiment, the display panel 10 may not be bent. The sub-area SR may be a non-display area.

A data driver 20 may be placed in the sub-area SR of the display panel 10. The data driver 20 may be placed in the display panel 10 in the form of an integrated circuit (IC). For example, the data driver 20 may be a data driving IC that generates a data signal.

A display circuit board 30 may be attached to an end of the sub-area SR of the display panel 10. The display circuit board 30 may be electrically connected to the data driver 20 and the like through a pad of the sub-area SR of the display panel 10.

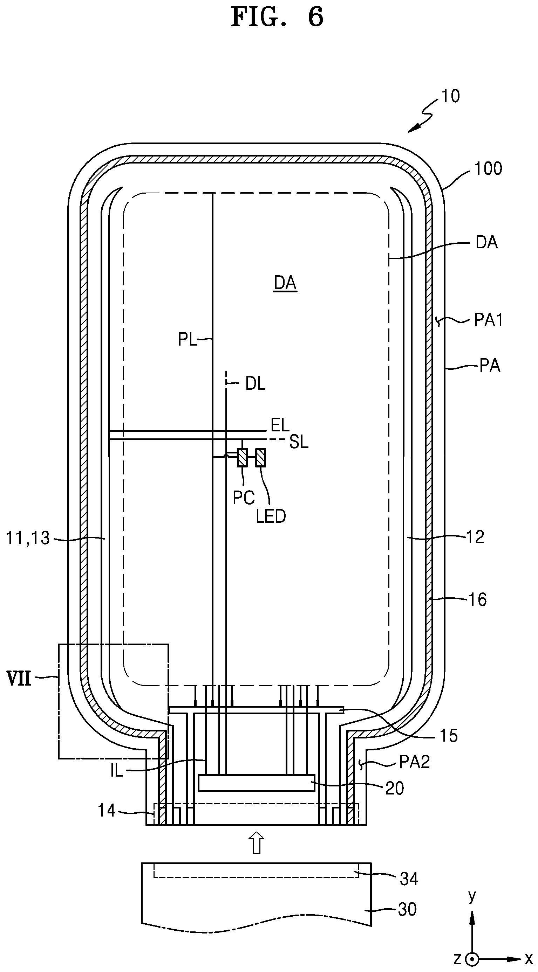

FIG. 6 is a schematic plan view showing a display panel 10 according to an embodiment.

Referring to FIG. 6, the display panel 10 may include a substrate 100. Various components forming the display panel 10 may be arranged on the substrate 100.

The substrate 100 may include glass, metal, or polymer resin, or a combination thereof. The substrate 100 may include a polymer resin, such as polyethersulphone, polyacrylate, polyetherimide, polyethylene naphthalate, polyethylene terephthalate, polyphenylene sulfide, polyarylate, polyimide, polycarbonate, or cellulose acetate propionate, or a combination thereof. The substrate 100 may have a multi-layer structure including two layers including the aforementioned polymer resin and an inorganic layer arranged between the two layers.

Pixels may be arranged in the display area DA, and the display area DA may provide an image by using light emitted from the pixels. Each pixel may include a light-emitting diode LED, and the light-emitting diode LED may be electrically connected to a pixel circuit PC. The pixel circuit PC and the light-emitting diode LED may be placed in the display area DA.

A gate driving circuit (e.g., a first scan driving circuit 11, a second scan driving circuit 12, and an emission control driving circuit 13), a pad 14, a first power supply line 15, and a second power supply line 16 may be arranged in the peripheral area PA.

The first scan driving circuit 11 may provide a scan signal to the pixel circuit PC through a gate line SL. The second scan driving circuit 12 may be arranged on an opposite side of the first scan driving circuit 11 with the display area DA between the second scan driving circuit 12 and the first scan driving circuit 11. Some of the pixel circuits PC arranged in the display area DA may be electrically connected to the first scan driving circuit 11, and the other pixel circuits PC arranged in the display area DA may be electrically connected to the second scan driving circuit 12. In another embodiment, the second scan driving circuit 12 may be omitted.

The emission control driving circuit 13 may be arranged on a side of the first scan driving circuit 11 and may provide an emission control signal to the pixel P through an emission control line EL. In FIG. 6, the emission control driving circuit 13 may be arranged on a side of the display area DA. However, embodiments of the disclosure are not limited thereto. In another embodiment, the emission control driving circuits 13 may be arranged on both sides of the display area DA.

The pad 14 may be arranged in the second peripheral area PA2 of the substrate 100. The pad 14 may be exposed without being covered by an insulating layer and be electrically connected to the display circuit board 30. A pad 34 of the display circuit board 30 may be electrically connected to the pad 14 of the display panel 10.

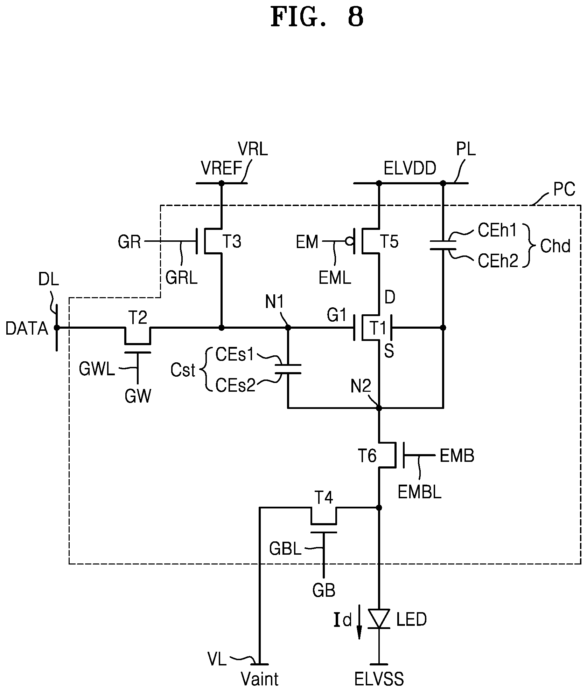

The display circuit board 30 may transmit a signal or power of a controller (not shown) to the display panel 10. Control signals generated by the controller may be transmitted to the gate driving circuit through the display circuit board 30. The controller may provide first and second power voltages ELVDD and ELVSS (see FIG. 8) to the first and second power supply lines 15 and 16, respectively. The first power voltage ELVDD (hereinafter, referred to as driving voltage) may be provided to each pixel circuit PC through the driving voltage line PL electrically connected to the first power supply line 15, and the second power voltage ELVSS (hereinafter, referred to as common voltage) may be provided to an opposite electrode of the light-emitting diode LED electrically connected to the second power supply line 16. The first power supply line 15 may extend in a first direction (e.g., the x-axis direction). The second power supply line 16 may have a loop shape with one side open and may partially surround the display area DA.

A data signal of the data driver 20 may be transmitted to the pixel circuit PC through an input line IL and a data line DL electrically connected to the input line IL.

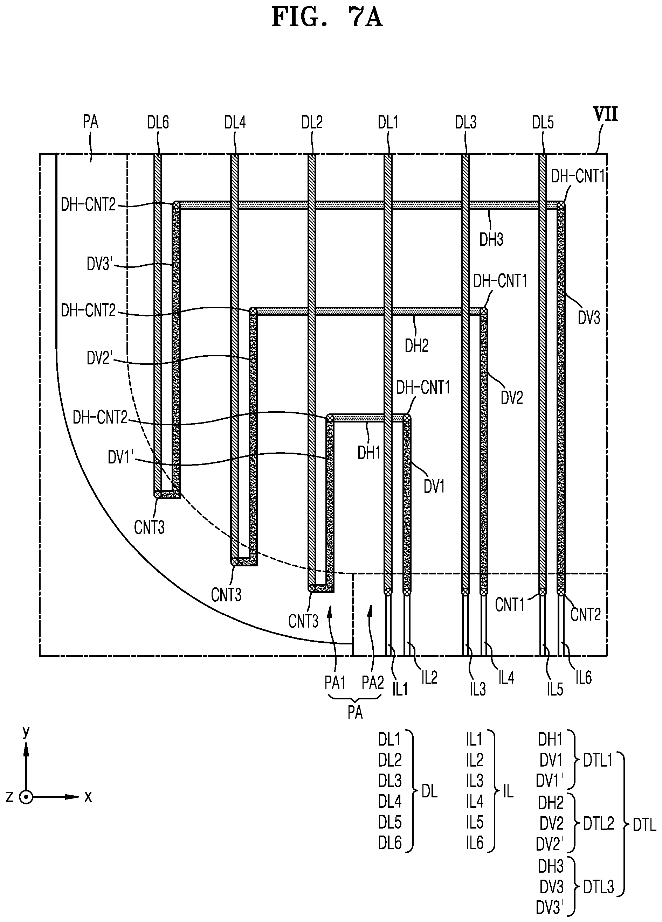

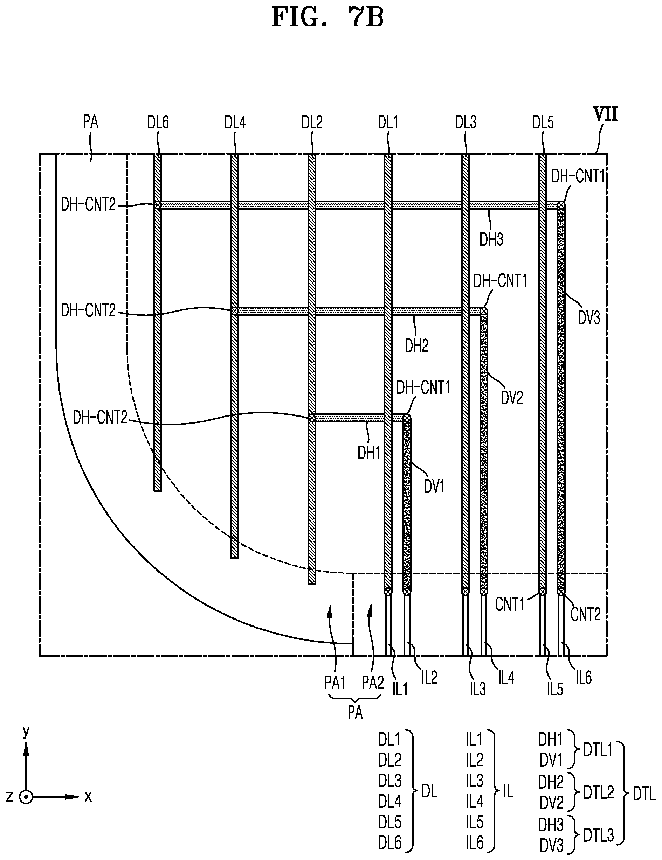

FIGS. 7A and 7B are enlarged schematic plan views of an area VII of FIG. 6, respectively, which is a portion of the display panel 10 according to an embodiment.

Referring to FIG. 7A, the data line DL extending in a second direction (e.g., the y-axis direction) may be arranged in the display area DA, and the input line IL may be arranged in the peripheral area PA. The input line IL may transmit the data signal of the data driver 20 (see FIG. 6) to the data line DL. For convenience of description, FIG. 7 illustrates a case where the data line DL may include first to sixth data lines DL1, DL2, DL3, DL4, DL5, and DL6 and the input line IL may include first to sixth input lines IL1, IL2, IL3, IL4, IL5, and IL6. However, the number of data lines DL and the number of input lines IL may be seven or more.

Some of the data lines DL may be directly electrically connected to (and directly contact) input lines, but other of the data lines DL may be electrically connected to input lines through a data transmission line DTL between the input line IL and the data line DL corresponding thereto.

In an embodiment, the first, third, and fifth data lines DL1, DL3, and DL5 may receive data signals from the first, third, and fifth input lines IL1, IL3, and IL5, respectively. The first, third, and fifth input lines IL1, IL3, and IL5 may be electrically connected to the first, third, and fifth data lines DL1, DL3, and DL5, respectively. The first, third, and fifth input lines IL1, IL3, and IL5 may be integral with the first, third, and fifth data lines DL1, DL3, DL5, respectively, or may be electrically connected to the first, third, and fifth data lines DL1, DL3, DL5, respectively, through a first contact hole CNT1, as shown in FIGS. 7A and 7B.

In an embodiment, the second, fourth, and sixth data lines DL2, DL4, and DL6 may receive data signals from the second, fourth, and sixth input lines IL2, IL4, IL6 via first to third data transmission lines DTL1, DTL2, and DTL3, respectively. The second, fourth, and sixth input lines IL2, IL4, and IL6 may be electrically connected to the second, fourth, and sixth data lines DL2, DL4, and DL6 through the first to third data transmission lines DTL1, DTL2, and DTL3, respectively.

The first to third data transmission lines DTL1, DTL2, and DTL3 may be arranged in the display area DA. The second input line IL2 may be electrically connected to the second data line DL2 through the first data transmission line DTL1, the fourth input line IL4 may be electrically connected to the fourth data line DL4 through the second data transmission line DTL2, and the sixth input line IL6 may be electrically connected to the sixth data line DL6 through the third data transmission line DTL3.

An end of each of the first to third data transmission lines DTL1, DTL2, and DTL3 may be electrically connected to the second, fourth, and sixth input lines IL2, IL4, and IL6, respectively, through a second contact hole CNT2, and another end of each of the first to third data transmission lines DTL1, DTL2, and DTL3 may be electrically connected to the second, fourth, and sixth data lines DL2, DL4, and DL6, respectively, through a third contact hole CNT3. Although FIG. 7 illustrates that the second contact hole CNT2 and the third contact hole CNT3 are located in the peripheral area PA, embodiments of the disclosure are not limited thereto. In another embodiment, the second contact hole CNT2 and/or the third contact hole CNT3 may be located in the display area DA.

In an embodiment, the first data transmission line DTL1 may include a first connection line DH1, a second connection line DV1, and a third connection line DV1', the second data transmission line DTL2 may include a first connection line DH2, a second connection line DV2, and a third connection line DV2', and the third data transmission line DTL3 may include a first connection line DH3, a second connection line DV3, and a third connection line DV3'. The first connection lines DH1, DH2, and DH3 may extend in the first direction (e.g., the the x-axis direction), and the second connection lines DV1, DV2, and DV3 and the third connection lines DV1', DV2', and DV3' may extend in the second direction (e.g., the y-axis direction) substantially parallel to the data line DL.

The second, fourth, and sixth input lines IL2, IL4, IL6 may be respectively electrically connected to the second connection lines DV1, DV2, and DV3 through the second contact hole CNT2, and the third connection lines DV1', DV2', and DV3' may be respectively electrically connected to the second, fourth, and sixth data lines DL2, DL4, and DL6 through the third contact hole CNT3. The first connection line DH1 may be electrically connected to the second connection line DV1 and the third connection line DV1' through a first connection contact hole DH-CNT1 and a second connection contact hole DH-CNT2, the first connection line DH2 may be electrically connected to the second connection line DV2 and the third connection line DV2' through the first connection contact hole DH-CNT1 and the second connection contact hole DH-CNT2, and the first connection line DH3 may be electrically connected to the second connection line DV3 and the third connection line DV3' through the first connection contact hole DH-CNT1 and the second connection contact hole DH-CNT2.

In an embodiment, the second connection lines DV1, DV2, and DV3 and the third connection lines DV1', DV2', and DV3' may be arranged on a same layer, and the first connection lines DH1, DH2, and DH3 may be arranged on a different layer from the second connection lines DV1, DV2, and DV3 and the third connection lines DV1', DV2', and DV3'. In case that connection lines are arranged on a same layer may mean that the connection lines may be simultaneously formed through a same mask process and may include a same material.

Although FIG. 7A illustrates that the first data transmission line DTL1 includes the first connection line DH1, the second connection line DV1, and the third connection line DV1', the second data transmission line DTL2 may include the first connection line DH2, the second connection line DV2, and the third connection line DV2', and the third data transmission line DTL3 may include the first connection line DH3, the second connection line DV3, and the third connection line DV3', embodiments of the disclosure are not limited thereto. In another embodiment, as illustrated in FIG. 7B, the first data transmission line DTL1 may include a first connection line DH1 and a second connection line DV1, the second data transmission line DTL2 may include a first connection line DH2 and a second connection line DV2, and the third data transmission line DTL3 may include a first connection line DH3 and a second connection line DV3. The second connection lines DV1, DV2, and DV3 may be electrically connected to data lines, for example, the second, fourth, and sixth data lines DL2, DL4, and DL6, respectively, through a second connection contact hole DH-CNT2.

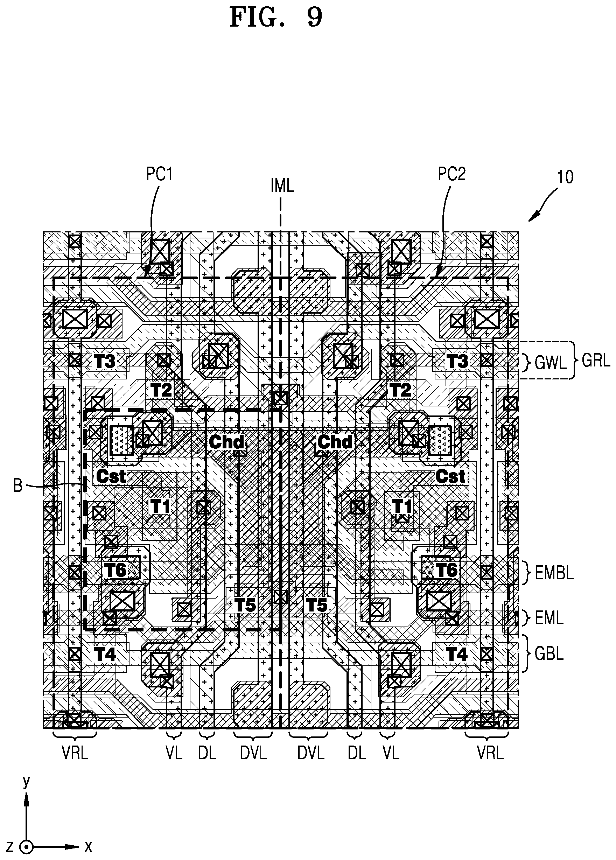

Although FIGS. 7A and 7B illustrate a structure in which one connection line extending in the second direction (e.g., the y-axis direction) is arranged between two adjacent data lines DL, embodiments of the disclosure are not limited thereto. In another embodiment, two connection lines (e.g., data connection lines DVL in FIG. 9) may be arranged between two adjacent data lines DL as in an embodiment to be described with reference to FIG. 9.

FIG. 8 is a schematic diagram of an equivalent circuit of a light-emitting diode LED and a pixel circuit PC of the display panel 10 according to an embodiment.

Referring to FIG. 8, the pixel circuit PC electrically connected to the light-emitting diode LED may include transistors and capacitors. In an embodiment, the pixel circuit PC may include first to sixth transistors T1, T2, T3, T4, T5, and T6, a storage capacitor Cst, and a hold capacitor Chd. The first transistor T1 may be a driving transistor that outputs a driving current corresponding to a data signal, and the second to sixth transistors T2, T3, T4, T5, and T6 may be switching transistors that transfer signals. A first terminal (first electrode) of each of the first to sixth transistors T1, T2, T3, T4, T5, and T6 may be a source or a drain, and a second terminal (second electrode) of each of the first to sixth transistors T1, T2, T3, T4, T5, and T6 may be a terminal different from the first terminal. For example, in case that the first terminal is a drain, the second terminal may be a source.

In an embodiment, at least one of the first to sixth transistors T1, T2, T3, T4, T5, and T6 may be a p-channel metal oxide semiconductor field-effect transistor (p-channel MOSFET) (PMOS), and other of the first to sixth transistors T1, T2, T3, T4, T5, and T6 may be n-channel MOSFETs (NMOSs). For example, the fifth transistor T5 may be a PMOS, and the first, second, third, fourth, and sixth transistors T1, T2, T3, T4, and T6 may be NMOSs. In another embodiment, the fifth transistor T5 and the sixth transistor T6 may be PMOSs, and the first, second, third, and fourth transistors T1, T2, T3, and T4 may be NMOSs. In another embodiment, the first to sixth transistors T1, T2, T3, T4, T5, and T6 may all be NMOSs or all be PMOSs. The following description focuses on an embodiment in which the fifth transistor T5 is a PMOS including a silicon semiconductor and the first, second, third, fourth, and sixth transistors T1, T2, T3, T4, and T6 are NMOSs including an oxide semiconductor.

At least one of the transistors T1, T2, T3, T4, T5, and T6 may be a transistor having a low-temperature polycrystalline silicon (LTPS) semiconductor layer, and at least one of the transistors T1, T2, T3, T4, T5, and T6 may be a transistor having an oxide semiconductor layer. For example, the fifth transistor T5 may include a semiconductor layer made of polycrystalline silicon having high reliability, and the first, second, third, fourth, and sixth transistors T1, T2, T3, T4, and T6 may include oxide semiconductor layers having high carrier mobility and low leakage current.

The pixel circuit PC may be electrically connected to a gate line that transmits a signal to each of the gates of the first to sixth transistors T1, T2, T3, T4, T5, and T6. For example, the pixel circuit PC may be electrically connected to a scan line GWL that transmits a scan signal GW, an initialization gate line GBL that transmits an initialization signal GB, a reference gate line GRL that transmits a reference signal GR, a first emission control line EML that transmits a first emission control signal EM, a second emission control line EMBL that transmits a second emission control signal EMB, and a data line DL that transmits a data signal DATA. The pixel circuit PC may be electrically connected to a driving voltage line PL that transmits a driving voltage ELVDD, a reference voltage line VRL that transmits a reference voltage VREF, and an initialization voltage line VL that transmits an initialization voltage Vaint.

The first transistor T1 may be electrically connected between the driving voltage line PL and a second node N2. The first transistor T1 may include a gate G1 electrically connected to a first node N1, a first terminal electrically connected to the driving voltage line PL, and a second terminal electrically connected to the second node N2. The first terminal may be a drain D and the second terminal may be a source S. The first transistor T1 may have a dual gate structure. In addition to the gate G1 electrically connected to the first node N1, the first transistor T1 may further include a lower gate electrode overlapping a channel region of the first transistor T1. The lower gate electrode may be electrically connected to the second node N2 and a second hold electrode CEh2 of the hold capacitor Chd.

The first terminal of the first transistor T1 may be electrically connected to the driving voltage line PL via the fifth transistor T5, and the second terminal of the first transistor T1 may be electrically connected to a pixel electrode of the light-emitting diode LED. The first transistor T1 may receive the data signal DATA according to the switching operation of the second transistor T2 and control the current amount of a driving current Id flowing to the light-emitting diode LED.

The second transistor T2 may be electrically connected between the data line DL and the first node N1. The second transistor T2 may include a gate electrically connected to the scan line GWL, a first terminal electrically connected to the data line DL, and a second terminal electrically connected to the first node N1. The second transistor T2 may be turned on by the scan signal GW transmitted to the scan line GWL to electrically connect the data line DL to the first node N1, and to transmit the data signal DATA transmitted to the data line DL to the first node N1.

The third transistor T3 may be electrically connected between the first node N1 and the reference voltage line VRL. The third transistor T3 may include a gate electrically connected to the reference gate line GRL, a first terminal electrically connected to the first node N1, and a second terminal electrically connected to the reference voltage line VRL. The third transistor T3 may be turned on by the reference signal GR transmitted to the reference gate line GRL and transmit the reference voltage VREF transmitted to the reference voltage line VRL to the first node N1.

The fourth transistor T4 may be electrically connected between the first transistor T1 and the initialization voltage line VL. The fourth transistor T4 may include a gate electrically connected to the initialization gate line GBL, a first terminal electrically connected to a second terminal of the sixth transistor T6 and the light-emitting diode LED, and a second terminal electrically connected to the initialization voltage line VL. The fourth transistor T4 may be turned on by the initialization signal GB transmitted to the initialization gate line GBL and transmit the initialization voltage Vaint transmitted to the initialization voltage line VL to the pixel electrode of the light-emitting diode LED.

The fifth transistor T5 may be electrically connected between the driving voltage line PL and the first transistor T1. The fifth transistor T5 may include a gate electrically connected to the first emission control line EML, a first terminal electrically connected to the driving voltage line PL, and a second terminal electrically connected to the first terminal of the first transistor T1. The fifth transistor T5 may be turned on or off according to the first emission control signal EM transmitted to the first emission control line EML.

The sixth transistor T6 may be electrically connected between the first transistor T1 and the light-emitting diode LED. The sixth transistor T6 may include a gate electrically connected to the second emission control line EMBL, a first terminal electrically connected to the second node N2, and a second terminal electrically connected to the light-emitting diode LED. The sixth transistor T6 may be turned on by the second emission control signal EMB transmitted to the second emission control line EMBL to connect the second node N2 and the pixel electrode of the light-emitting diode LED to each other.

Although FIG. 8 illustrates that the fifth transistor T5 and the sixth transistor T6 operate in response to different emission control signals EM and EMB, embodiments of the disclosure are not limited thereto. In another embodiment, the fifth transistor T5 and the sixth transistor T6 may operate in response to a same emission control signal.

In an embodiment, the reference signal GR may be substantially synchronized with the scan signal GW of the pixel circuit PC located in a previous row. The initialization signal GB may be substantially synchronized with the scan signal GW. In another embodiment, the initialization signal GB may be substantially synchronized with the scan signal GW or the reference signal GR of the pixel circuit PC located in a next row.

The storage capacitor Cst may be electrically connected between the first node N1 and the second node N2. In other words, the pixel circuit PC according to an embodiment may be a source follower type circuit in which the storage capacitor Cst may be electrically connected between the first node N1 and the second node N2. A first storage electrode CEs1 of the storage capacitor Cst may be electrically connected to the first node N1, and a second storage electrode CEs2 of the storage capacitor Cst may be electrically connected to the second node N2. The storage capacitor Cst may store a voltage corresponding to the threshold voltage of the first transistor T1 and the data signal DATA.

In an embodiment, the hold capacitor Chd may be electrically connected between the driving voltage line PL and the second node N2. A first hold electrode CEh1 of the hold capacitor Chd may be electrically connected to the driving voltage line PL, and a second hold electrode CEh2 of the hold capacitor Chd may be electrically connected to the second node N2. The hold capacitor Chd may allow the voltage of the lower gate electrode of the first transistor T1 and the second node N2 to remain constant and not fluctuate even when a peripheral signal fluctuates.

The light-emitting diode LED may include a pixel electrode electrically connected to the second node N2 and an opposite electrode on the pixel electrode, and the opposite electrode may be supplied with the common voltage ELVSS. The opposite electrode may be a common electrode shared by light-emitting diodes LED.

Although FIG. 8 illustrates that the pixel circuit PC includes six transistors and two capacitors, embodiments of the disclosure are not limited thereto. In another embodiment, the pixel circuit PC may include five transistors and two capacitors. In another embodiment, the pixel circuit PC may include seven transistors and two capacitors.

FIG. 9 is a schematic plan view illustrating pixel circuits of a display panel 10 according to an embodiment. For convenience of description, FIG. 9 illustrates two pixel circuits, for example, a first pixel circuit PC1 and a second pixel circuit PC2, arranged in a same row in a first direction (e.g., the x-axis direction). However, embodiments of the disclosure are not limited thereto. The display panel 10 may include pixel circuits arranged in rows in the first direction (e.g., the x-axis direction) and in columns in a second direction (e.g., the y-axis direction).

Referring to FIG. 9, each of the first pixel circuit PC1 and the second pixel circuit PC2 may include transistors and capacitors. In an embodiment, each of the first pixel circuit PC1 and the second pixel circuit PC2 may include the first to sixth transistors T1, T2, T3, T4, T5, and T6, the storage capacitor Cst, and the hold capacitor Chd, described above with reference to FIG. 8.

The transistors and capacitors of the first pixel circuit PC1 may be arranged symmetrically with the transistors and capacitors of the second pixel circuit PC2, respectively. For example, the first transistor T1 of the first pixel circuit PC1 may be symmetrical with the first transistor T1 of the second pixel circuit PC2 with respect to an imaginary line IML passing between the first pixel circuit PC1 and the second pixel circuit PC2 in the second direction (e.g., the y-axis direction). Similarly, the second to sixth transistors T2, T3, T4, T5, and T6, the storage capacitor Cst, and the hold capacitor Chd of the first pixel circuit PC1 may be symmetrical with the second to sixth transistors T2, T3, T4, T5, and T6, the storage capacitor Cst, and the hold capacitor Chd of the second pixel circuit PC2, respectively, with respect to the imaginary line IML.

Gate lines electrically connected to the first pixel circuit PC1 and the second pixel circuit PC2, such as a scan line GWL, an initialization gate line GBL, a reference gate line GRL, a first emission control line EML, and a second emission control line EMBL, may extend in the first direction (e.g., the x-axis direction).

The first pixel circuit PC1 may be electrically connected to a data line DL passing through the first pixel circuit PC1, and the second pixel circuit PC2 may be electrically connected to a data line DL passing through the second pixel circuit PC2. The data line DL may extend in the second direction (e.g., the y-axis direction). The data line DL electrically connected to the first pixel circuit PC1 and the data line DL electrically connected to the second pixel circuit PC2 may be symmetrical with each other with respect to the imaginary line IML.

The first pixel circuit PC1 may be electrically connected to a voltage line passing through the first pixel circuit PC1, such as a reference voltage line VRL and an initialization voltage line VL. The second pixel circuit PC2 may be electrically connected to a voltage line passing through the second pixel circuit PC2, such as a reference voltage line VRL and an initialization voltage line VL. The reference voltage line VRL and the initialization voltage line VL electrically connected to the first pixel circuit PC1 may be symmetrical with the reference voltage line VRL and the initialization voltage line VL electrically connected to the second pixel circuit PC2, respectively, with respect to the imaginary line IML. The reference voltage line VRL and the initialization voltage line VL may each extend in the second direction (e.g., the y-axis direction).

In some embodiments, a data connection line DVL may extend in the second direction (e.g., the y-axis direction). The data connection line DVL may be a signal line corresponding to a portion of the data transmission line DTL described above with reference to FIG. 7, for example, to one of the second connection lines DV1, DV2, and DV3 and third connection lines DV1', DV2', and DV3'. The data connection line DVL may be electrically connected to data lines of pixel circuits arranged in different columns from the first and second pixel circuits PC1 and PC2 illustrated in FIG. 9 and transmit data signals to the pixel circuits arranged in the different columns.

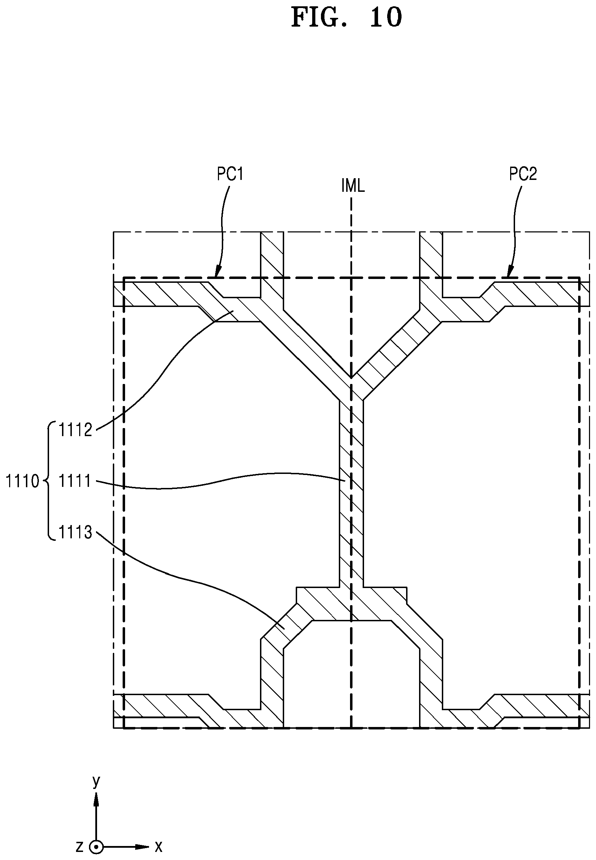

FIGS. 10 to 18 are schematic plan views according to a process of forming a pixel circuit of a display panel according to an embodiment. FIGS. 10 to 18 show a process of forming components corresponding to the first pixel circuit PC1 and the second pixel circuit PC2, described with reference to FIG. 9. For convenience of description, the first pixel circuit PC1 is described as being located in the (i)-th row and the (j)-th column, and the second pixel circuit PC2 is described as being located in the (i)-th row and the (j+1)-th column.

Referring to FIG. 10, a lower metal layer 1110 may be arranged on a substrate. The lower metal layer 1110 may include a first portion 1111 extending in the second direction (e.g., the y-axis direction), and a second portion 1112 and a third portion 1113 electrically connected to the first portion 1111 but extending in the first direction (e.g., the x-axis direction) as a whole.

In an embodiment, the first portion 1111 of the lower metal layer 1110 may be positioned on an imaginary line IML between the first pixel circuit PC1 and the second pixel circuit PC2. The second portion 1112 and the third portion 1113 of the lower metal layer 1110 may be positioned on opposite sides with the first portion 1111 between the second portion 1112 and the third portion 1113. The second portion 1112 and the third portion 1113 may extend in the first direction (e.g., the x-axis direction) as a whole, but may be locally bent.

The lower metal layer 1110 may include one or more materials selected from aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu). In some embodiments, the lower metal layer 1110 may be a single layer including molybdenum, may have a double layer structure in which a molybdenum layer and a titanium layer may be stacked each other, or may have a triple layer structure in which a titanium layer, an aluminum layer, and a titanium layer may be stacked each other.

The lower metal layer 1110 may have a voltage level of a constant voltage. For example, the lower metal layer 1110 may be electrically connected to the first power supply line 15 (see FIG. 6) at the outer edge of the display area DA of the display panel 10 (see FIG. 6).

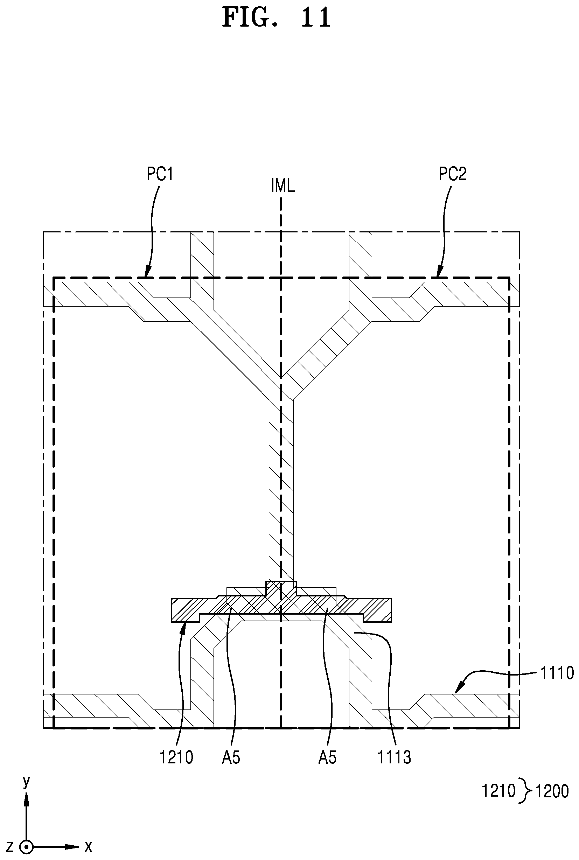

Referring to FIG. 11, a silicon semiconductor layer 1200 may be arranged on the lower metal layer 1110. Specifically, the silicon semiconductor layer 1200 may include amorphous silicon or polysilicon. For example, the silicon semiconductor layer 1200 may include polysilicon crystallized at a low temperature. The silicon semiconductor layer 1200 may include a first silicon semiconductor pattern 1210, as shown in FIG. 11.

The first silicon semiconductor pattern 1210 may have an isolated shape and may extend in the first direction (e.g., the x-axis direction). The first silicon semiconductor pattern 1210 may intersect the imaginary line IML between the first pixel circuit PC1 and the second pixel circuit PC2. The first silicon semiconductor pattern 1210 may include a fifth semiconductor layer A5 of each of the first pixel circuit PC1 and the second pixel circuit PC2. In other words, the fifth semiconductor layer A5 of the first pixel circuit PC1 and the fifth semiconductor layer A5 of the second pixel circuit PC2 may be integrally connected to each other.

The first silicon semiconductor pattern 1210 may overlap the lower metal layer 1110 in a third direction (e.g., the z-axis direction). For example, the first silicon semiconductor pattern 1210 may overlap the third portion 1113 of the lower metal layer 1110. The fifth semiconductor layer A5 of each of the first pixel circuit PC1 and the second pixel circuit PC2 may overlap the third portion 1113 of the lower metal layer 1110.

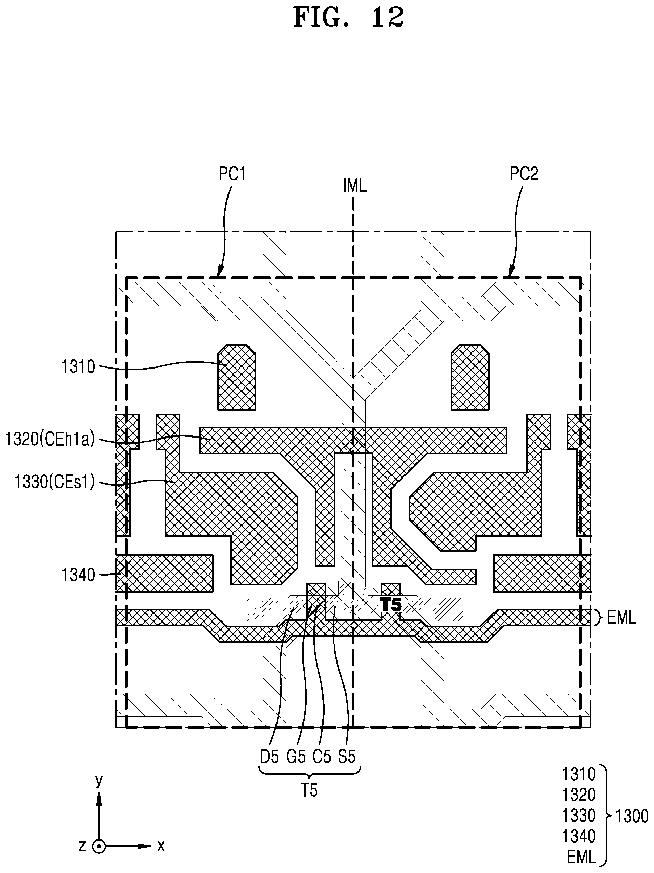

Referring to FIG. 12, a first conductive layer 1300 may be arranged on the silicon semiconductor layer 1200. The first conductive layer 1300 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials.

The first conductive layer 1300 may include an emission control line EML, a first conductive pattern 1310, a second conductive pattern 1320, a third conductive pattern 1330, and a fourth conductive pattern 1340. The first emission control line EML), the first conductive pattern 1310, the second conductive pattern 1320, the third conductive pattern 1330, and the fourth conductive pattern 1340 may be arranged to be spaced apart from each other.

The first emission control line EML may extend in the first direction (e.g., the x-axis direction) to pass through the first pixel circuit PC1 and the second pixel circuit PC2. The first emission control line EML may pass through pixel circuits arranged in a same row as the first pixel circuit PC1 and the second pixel circuit PC2.

The first emission control line EML may include a fifth gate electrode G5 of the fifth transistor T5 of each of the first pixel circuit PC1 and the second pixel circuit PC2. A portion of the first emission control line EML may protrude to overlap in a third direction (e.g., the z-axis direction) the fifth semiconductor layer A5 of the fifth transistor T5, and a portion of the protruding first emission control line EML may correspond to the fifth gate electrode G5 of the fifth transistor T5. The fifth semiconductor layer A5 (see FIG. 11) of the fifth transistor T5 may include a channel region C5 overlapping the fifth gate electrode G5 in a third direction (e.g., the z-axis direction), and doped regions S5 and D5 arranged on both sides of the channel region C5 in a first direction (e.g., the x-axis direction) and doped with impurities. A doped region S5 or D5 may be a source region and another doped region D5 or S5 may be a drain region. The source region and the drain region may correspond to a source electrode and a drain electrode, respectively. The position of the source region and the position of the drain region may be interchanged depending on the properties of the transistor.

The first conductive pattern 1310, the second conductive pattern 1320, the third conductive pattern 1330, and the fourth conductive pattern 1340 may be arranged in each of the first pixel circuit PC1 and the second pixel circuit PC2. The first conductive pattern 1310, the second conductive pattern 1320, the third conductive pattern 1330, and the fourth conductive pattern 1340 may each have an isolated shape. The first conductive pattern 1310, the third conductive pattern 1330, and the fourth conductive pattern 1340 of the first pixel circuit PC1 may be arranged symmetrically with the first conductive pattern 1310, the third conductive pattern 1330, and the fourth conductive pattern 1340 of the second pixel circuit PC2, respectively, with respect to the imaginary line IML.

The second conductive pattern 1320 may have an isolated shape and may extend in the first direction (e.g., the x-axis direction) to pass through the first pixel circuit PC1 and the second pixel circuit PC2. The second conductive pattern 1320 may intersect the imaginary line IML between the first pixel circuit PC1 and the second pixel circuit PC2. The second conductive pattern 1320 may include a stem portion extending in the first direction (e.g., the x-axis direction) and a branch portion branched from the stem portion and protruding in the second direction (e.g., the y-axis direction). The branch portion of the first pixel circuit PC1 and the branch portion of the second pixel circuit PC2 may be arranged symmetrically with each other with respect to the imaginary line IML between the first pixel circuit PC1 and the second pixel circuit PC2.

The second conductive pattern 1320 may include a first lower hold electrode CEh1a that may be a sub-layer of the first hold electrode CEh1 of the hold capacitor Chd described with reference to FIG. 8. In other words, the first lower hold electrode CEh1a of the first pixel circuit PC1 may be integral with the first lower hold electrode CEh1a of the second pixel circuit PC2.

The third conductive pattern 1330 located in each of the first pixel circuit PC1 and the second pixel circuit PC2 may include the first storage electrode CEs1 of the storage capacitor Cst described with reference to FIG. 8.

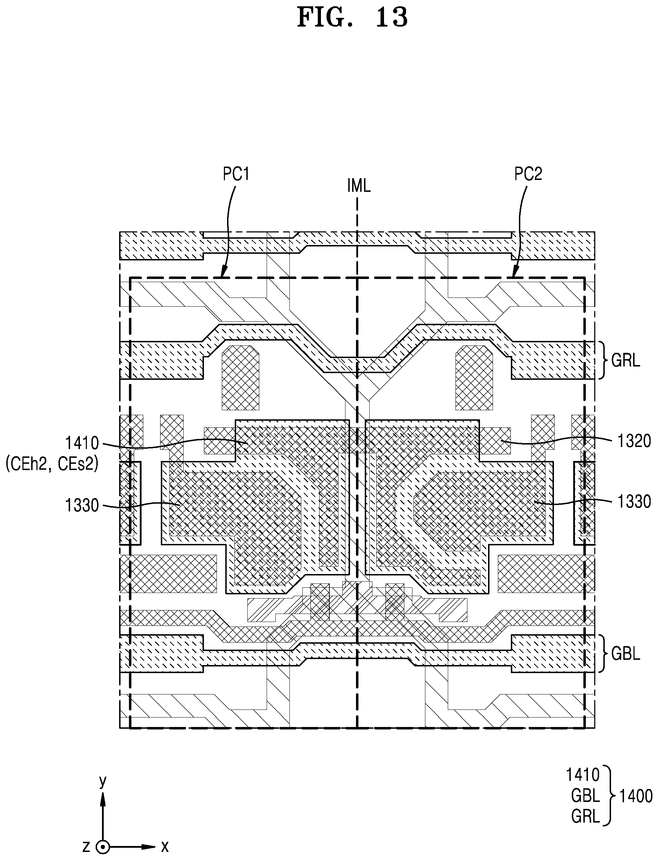

Referring to FIG. 13, a second conductive layer 1400 may be arranged on the first conductive layer 1300. The second conductive layer 1400 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials.

The second conductive layer 1400 may include an initialization gate line GBL, a reference gate line GRL, and a fifth conductive pattern 1410. The initialization gate line GBL, the reference gate line GRL, and the fifth conductive pattern 1410 may be arranged to be spaced apart from each other.

The initialization gate line GBL and the reference gate line GRL may each extend in the first direction (e.g., the x-axis direction) to pass through the first pixel circuit PC1 and the second pixel circuit PC2. The initialization gate line GBL and the reference gate line GRL may each pass through pixel circuits arranged in a same row as the first pixel circuit PC1 and the second pixel circuit PC2.

The fifth conductive pattern 1410 arranged in each of the first pixel circuit PC1 and the second pixel circuit PC2 may have an isolated shape. The fifth conductive pattern 1410 arranged in the first pixel circuit PC1 and the fifth conductive pattern 1410 arranged in the second pixel circuit PC2 may be spaced apart from each other and may be arranged substantially symmetrically with each other with respect to the imaginary line IML.

The fifth conductive pattern 1410 may overlap in a third direction (e.g., the z-axis direction) the third conductive pattern 1330 of the first pixel circuit PC1, the third conductive pattern 1330 of the second pixel circuit PC2, and the second conductive pattern 1320 passing through the first pixel circuit PC1 and the second pixel circuit PC2.

The fifth conductive pattern 1410 may include the second hold electrode CEh2 of the hold capacitor Chd (see FIG. 8) and the second storage electrode CEs2 of the storage capacitor Cst (see FIG. 8). In other words, the second hold electrode CEh2 of the hold capacitor Chd (see FIG. 8) and the second storage electrode CEs2 of the storage capacitor Cst (see FIG. 8) may be integral with each other.

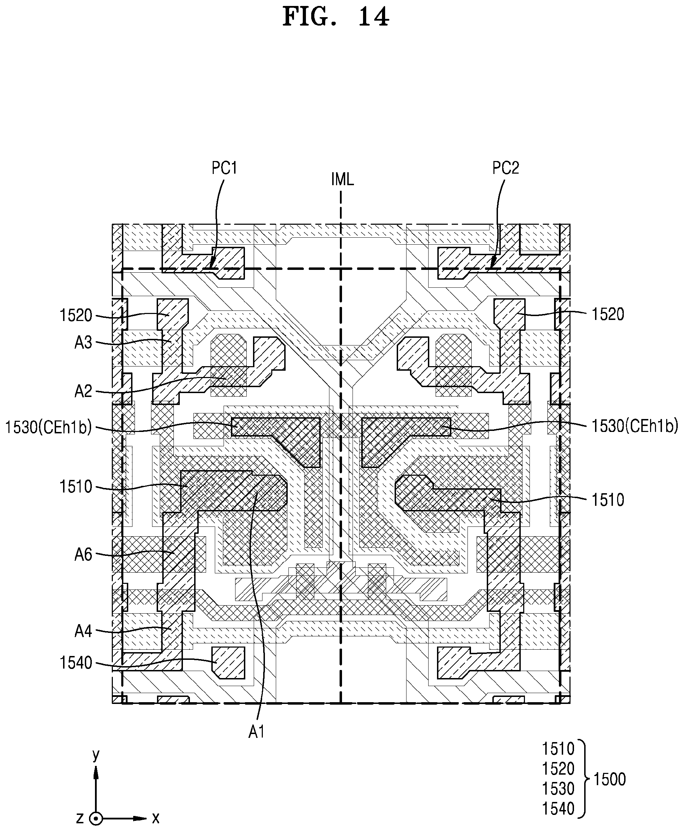

Referring to FIG. 14, an oxide semiconductor layer 1500 may be arranged on the second conductive layer 1400. Specifically, the oxide semiconductor layer 1500 may include an oxide semiconductor, and the oxide semiconductor may be an oxide semiconductor including at least one element selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn), or a combination thereof. For example, the oxide semiconductor layer 1500 may include InSnZnO (ITZO) or InGaZnO (IGZO).

The oxide semiconductor layer 1500 may include a first oxide semiconductor pattern 1510, a second oxide semiconductor pattern 1520, a third oxide semiconductor pattern 1530, and a fourth oxide semiconductor pattern 1540. The first oxide semiconductor pattern 1510, the second oxide semiconductor pattern 1520, the third oxide semiconductor pattern 1530, and the fourth oxide semiconductor pattern 1540 may be arranged to be spaced apart from each other.

The first oxide semiconductor pattern 1510 arranged in each of the first pixel circuit PC1 and the second pixel circuit PC2 may have an isolated shape. The first oxide semiconductor pattern 1510 may include a first semiconductor layer A1, a fourth semiconductor layer A4, and a sixth semiconductor layer A6. In other words, the first semiconductor layer A1, the fourth semiconductor layer A4, and the sixth semiconductor layer A6 of the first pixel circuit PC1 may be integral with each other, and the first semiconductor layer A1, the fourth semiconductor layer A4, and the sixth semiconductor layer A6 of the second pixel circuit PC2 may be integral with each other. The first oxide semiconductor pattern 1510 may have a shape that may be bent several times.

The first semiconductor layer A1, the fourth semiconductor layer A4, and the sixth semiconductor layer A6 may overlap in a third direction (e.g., the z-axis direction) the fifth conductive pattern 1410 and the initialization gate line GBL, described with reference to FIG. 13, and the fourth conductive pattern 1340 described with reference to FIG. 12, respectively.

In an embodiment, in a schematic plan view, the shape of the first oxide semiconductor pattern 1510 of the first pixel circuit PC1 and the shape of the first oxide semiconductor pattern 1510 of the second pixel circuit PC2 may be different from each other. A portion of the first oxide semiconductor pattern 1510 of the first pixel circuit PC1 may be placed in a pixel circuit that may be arranged in a same row as the first pixel circuit PC but in an adjacent column (e.g., the (i)-th row and the (j-1)-th column).

The second oxide semiconductor pattern 1520 arranged in each of the first pixel circuit PC1 and the second pixel circuit PC2 may have an isolated shape. The second oxide semiconductor pattern 1520 may be bent to have an approximately "L" shape. The second oxide semiconductor pattern 1520 of the first pixel circuit PC1 and the second oxide semiconductor pattern 1520 of the second pixel circuit PC2 may be arranged symmetrically with each other with respect to the imaginary line IML.

The second oxide semiconductor pattern 1520 may include a second semiconductor layer A2 of the second transistor T2 and a third semiconductor layer A3 of the third transistor T3. In other words, the second semiconductor layer A2 of the second transistor T2 and the third semiconductor layer A3 of the third transistor T3 may be integral with each other.

The second semiconductor layer A2 and the third semiconductor layer A3 may overlap in a third direction (e.g., the z-axis direction) the first conductive pattern 1310 described with reference to FIG. 12 and the reference gate line GRL described with reference to FIG. 13, respectively.

The third oxide semiconductor pattern 1530 arranged in each of the first pixel circuit PC1 and the second pixel circuit PC2 may have an isolated shape. The third oxide semiconductor pattern 1530 of the first pixel circuit PC1 and the third oxide semiconductor pattern 1530 of the second pixel circuit PC2 may be arranged symmetrically with each other with respect to the imaginary line IML.

The third oxide semiconductor pattern 1530 may overlap in a third direction (e.g., the z-axis direction) the fifth conductive pattern 1410 described with reference to FIG. 13 and the second conductive pattern 1320 described with reference to FIG. 12. The third oxide semiconductor pattern 1530 may include a first upper hold electrode CEh1b that may be a sub-layer of the first hold electrode CEh1 of the hold capacitor Chd (see FIG. 8).

The fourth oxide semiconductor pattern 1540 may be arranged in the first pixel circuit PC1. The fourth oxide semiconductor pattern 1540 may be arranged at a position corresponding to an end of the first oxide semiconductor pattern 1510 of the second pixel circuit PC1, and may correspond to a type of dummy electrode.

Each of the first oxide semiconductor pattern 1510, the second oxide semiconductor pattern 1520, the third oxide semiconductor pattern 1530, and the fourth oxide semiconductor pattern 1540 may include at least a partially conductive region. For example, a conductive process using plasma or the like may be performed on at least a portion of each of the first oxide semiconductor pattern 1510, the second oxide semiconductor pattern 1520, the third oxide semiconductor pattern 1530, and the fourth oxide semiconductor pattern 1540. In an embodiment, the entire area of the third oxide semiconductor pattern 1530 including the first upper hold electrode CEh1b may be conductive to form the hold capacitor Chd (see FIG. 8).

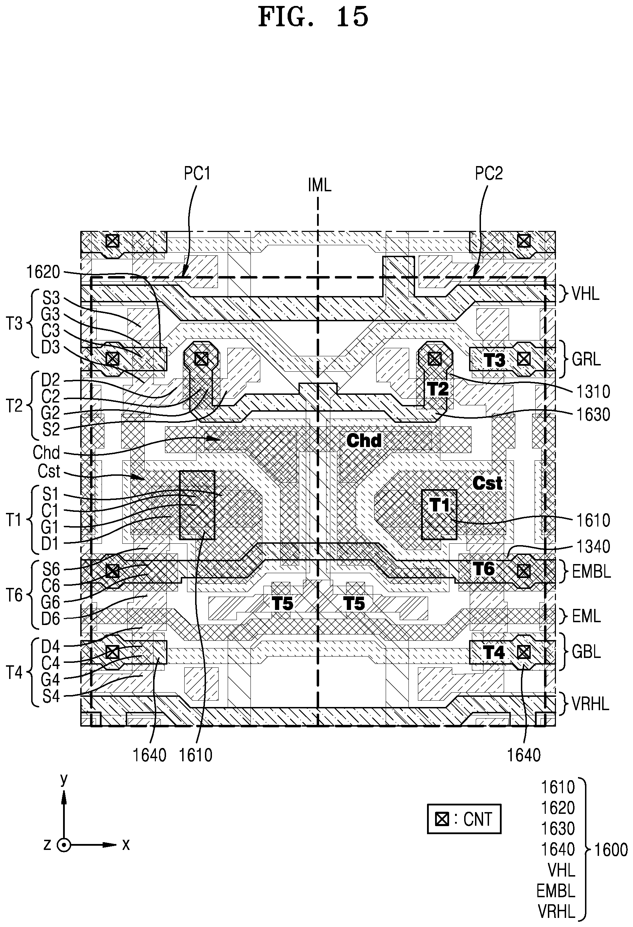

Referring to FIG. 15, a third conductive layer 1600 may be arranged on the oxide semiconductor layer 1500. The third conductive layer 1600 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials.

The third conductive layer 1600 may include a horizontal initialization voltage line VHL, a second emission control line EMBL, a horizontal reference voltage line VRHL, a sixth conductive pattern 1610, a seventh conductive pattern 1620, an eighth conductive pattern 1630, and a ninth conductive pattern 1640. The horizontal initialization voltage line VHL, the second emission control line EMBL, the horizontal reference voltage line VRHL, the sixth conductive pattern 1610, the seventh conductive pattern 1620, the eighth conductive pattern 1630, and the ninth conductive pattern 1640 may be arranged to be spaced apart from each other.

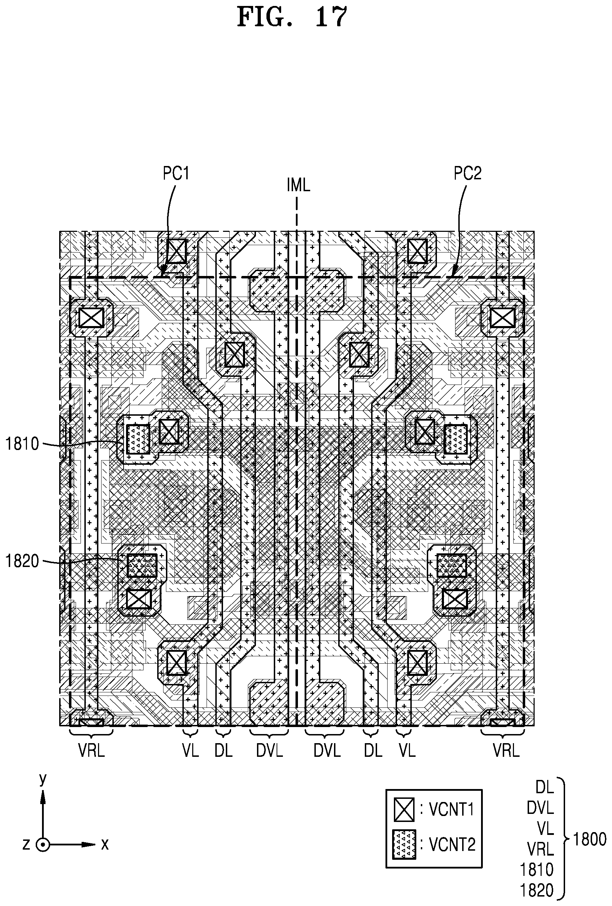

The horizontal initialization voltage line VHL may extend in the first direction (e.g., the x-axis direction) to pass through the first pixel circuit PC1 and the second pixel circuit PC2. The horizontal initialization voltage line VHL may be electrically connected to an initialization voltage line VL to be described below with reference to FIG. 17.

The second emission control line EMBL may extend in the first direction (e.g., the x-axis direction) to pass through the first pixel circuit PC1 and the second pixel circuit PC2. The second emission control line EMBL may pass through pixel circuits arranged in a same row as the first pixel circuit PC1 and the second pixel circuit PC2.

The horizontal reference voltage line VRHL may extend in the first direction (e.g., the x-axis direction) to pass through the first pixel circuit PC1 and the second pixel circuit PC2. The horizontal reference voltage line VRHL may be electrically connected to a reference voltage line VRL to be described below with reference to FIG. 17.

The sixth conductive pattern 1610, the seventh conductive pattern 1620, and the ninth conductive pattern 1640 arranged in each of the first pixel circuit PC1 and the second pixel circuit PC2 may each have an isolated shape. The sixth conductive pattern 1610, the seventh conductive pattern 1620, and the ninth conductive pattern 1640 of the first pixel circuit PC1 may be arranged symmetrically with the sixth conductive pattern 1610, the seventh conductive pattern 1620, and the ninth conductive pattern 1640 of the second pixel circuit PC2 with respect to the imaginary line IML.

The eighth conductive pattern 1630 may have an isolated shape, but may extend in the first direction (e.g., the the x-axis direction). The eighth conductive pattern 1630 may be arranged across the first pixel circuit PC1 and the second pixel circuit PC2. The eighth conductive pattern 1630 may intersect the imaginary line IML.

The sixth conductive pattern 1610, the seventh conductive pattern 1620, the eighth conductive pattern 1630, the ninth conductive pattern 1640, and the second emission control line EMBL may include gate electrodes of transistors.

The sixth conductive pattern 1610 of each of the first pixel circuit PC1 and the second pixel circuit PC2 may include a first gate electrode G1 of the first transistor T1. Referring to FIGS. 14 and 15, the first semiconductor layer A1 of the first transistor T1 may include a channel region C1 overlapping in a third direction (e.g., the z-axis direction) the sixth conductive pattern 1610 and conductive regions S1 and D1 arranged on both sides of the channel region C1 in a first direction (e.g., the x-axis direction). A conductive region S1 or D1 may be a source region and another conductive region D1 or S1 may be a drain region. The source region and the drain region may correspond to a source electrode and a drain electrode, respectively. The positions of the source region and the drain region may be interchanged depending on the properties of the transistor. For example, a portion of the fifth conductive pattern 1410 (see FIG. 13) and the first gate electrode G1 may overlap each other in a third direction (e.g., the z-axis direction) with the channel region C1 between the portion of the fifth conductive pattern 1410 and the first gate electrode G1. A portion of the fifth conductive pattern 1410 (see FIG. 13) overlapping the channel region C1 of the first transistor T1 may correspond to the lower gate electrode of the first transistor T1.

The seventh conductive pattern 1620 of each of the first pixel circuit PC1 and the second pixel circuit PC2 may include a third gate electrode G3 of the third transistor T3. Referring to FIGS. 14 and 15, the third semiconductor layer A3 of the third transistor T3 may include a channel region C3 overlapping in a third direction (e.g., the z-axis direction) the seventh conductive pattern 1620 and conductive regions S3 and D3 arranged on both sides of the channel region C3 in the second direction (e.g., the y-axis direction). A conductive region S3 or D3 may be a source region and another conductive region D3 or S3 may be a drain region. The source region and the drain region may correspond to a source electrode and a drain electrode, respectively. The positions of the source region and the drain region may be interchanged depending on the properties of the transistor.

The seventh conductive pattern 1620 may be electrically connected to a reference gate line GRL arranged below the third semiconductor layer A3 (see FIG. 14) in a third direction (e.g., the z-axis direction) through a contact hole CNT. The seventh conductive pattern 1620 and a portion of the reference gate line GRL may overlap each other in a third direction (e.g., the z-axis direction) with the channel region C3 of the third transistor T3 between the seventh conductive pattern 1620 and the portion of the reference gate line GRL. A portion of the reference gate line GRL overlapping the channel region C3 of the third transistor T3 may correspond to the lower gate electrode of the third transistor T3, and the switching performance of the third transistor T3 may be improved through this dual gate structure.

The eighth conductive pattern 1630 may include a second gate electrode G2 of the second transistor T2. Referring to FIGS. 14 and 15, the second semiconductor layer A2 of the second transistor T2 may include a channel region C2 overlapping in a third direction (e.g., the z-axis direction) the eighth conductive pattern 1630 and conductive regions S2 and D2 arranged on both sides of the channel region C2 in a first direction (e.g., the x-axis direction). A conductive region S2 or D2 may be a source region and another conductive region D2 or S2 may be a drain region. The source region and the drain region may correspond to a source electrode and a drain electrode, respectively. The positions of the source region and the drain region may be interchanged depending on the properties of the transistor.

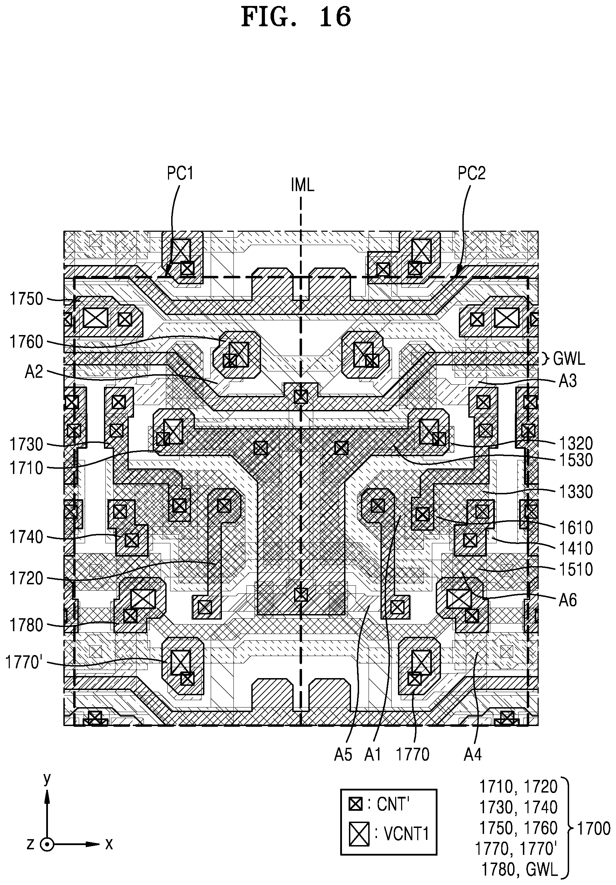

The eighth conductive pattern 1630 may be electrically connected to a scan line GWL to be described below with reference to FIG. 16. The eighth conductive pattern 1630 may be electrically connected to the first conductive pattern 1310 arranged below the second semiconductor layer A2 (see FIG. 14) through a contact hole CNT. The eighth conductive pattern 1630 and the first conductive pattern 1310 may overlap each other in a third direction (e.g., the z-axis direction) with the channel region C2 of the second transistor T2 between the eighth conductive pattern 1630 and the first conductive pattern 1310. The first conductive pattern 1310 may correspond to the lower gate electrode of the second transistor T2, and the switching performance of the second transistor T2 may be improved through this dual gate structure.

The ninth conductive pattern 1640 of each of the first pixel circuit PC1 and the second pixel circuit PC2 may include a fourth gate electrode G4 of the fourth transistor T4. Referring to FIGS. 14 and 15, the fourth semiconductor layer A4 of the fourth transistor T4 may include a channel region C4 overlapping in a third direction (e.g., the z-axis direction) the ninth conductive pattern 1640 and conductive regions S4 and D4 arranged on both sides of the channel region C4 in the second direction (e.g., the y-axis direction). A conductive region S4 or D4 may be a source region and another conductive region D4 or S4 may be a drain region. The source region and the drain region may correspond to a source electrode and a drain electrode, respectively. The positions of the source region and the drain region may be interchanged depending on the properties of the transistor.

The ninth conductive pattern 1640 may be electrically connected to an initialization gate line GBL arranged below the fourth semiconductor layer A4 (see FIG. 14) through a contact hole CNT. The ninth conductive pattern 1640 and a portion of the initialization gate line GBL may overlap each other in a third direction (e.g., the z-axis direction) with the channel region C4 of the fourth transistor T4 between the ninth conductive pattern 1640 and the portion of the initialization gate line GBL. A portion of the initialization gate line GBL overlapping the channel region C4 of the fourth transistor T4 may correspond to the lower gate electrode of the fourth transistor T4, and the switching performance of the fourth transistor T4 may be improved through this dual gate structure.

The second emission control line EMBL may include a sixth gate electrode G6 of the sixth transistor T6. Referring to FIGS. 14 and 15, the sixth semiconductor layer A6 of the sixth transistor T6 may include a channel region C6 overlapping in a third direction (e.g., the z-axis direction) the second emission control line EMBL and conductive regions S6 and D6 arranged on both sides of the channel region C6 in the second direction (e.g., the y-axis direction). A conductive region S6 or D6 may be a source region and another conductive region D6 or S6 may be a drain region. The source region and the drain region may correspond to a source electrode and a drain electrode, respectively. The positions of the source region and the drain region may be interchanged depending on the properties of the transistor.

The second emission control line EMBL may be electrically connected to the fourth conductive pattern 1340 arranged below the sixth semiconductor layer A6 (see FIG. 14) through a contact hole CNT. A portion of the second emission control line EMBL and the fourth conductive pattern 1340 may overlap each other in a third direction (e.g., the z-axis direction) with the channel region C6 of the sixth transistor T6 between the portion of the second emission control line EMBL and the fourth conductive pattern 1340. The fourth conductive pattern 1340 may correspond to the lower gate electrode of the sixth transistor T6, and the switching performance of the fourth transistor T4 may be improved through this dual gate structure.

Referring to FIG. 16, a fourth conductive layer 1700 may be arranged on the third conductive layer 1600. The fourth conductive layer 1700 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials.

The fourth conductive layer 1700 may include a scan line GWL and tenth to seventeenth conductive patterns 1710, 1720, 1730, 1740, 1750, 1760, 1770, and 1780. The scan line GWL and the tenth to seventeenth conductive patterns 1710, 1720, 1730, 1740, 1750, 1760, 1770, and 1780 may be arranged to be spaced apart from each other.

The scan line GWL may extend in the first direction (e.g., the x-axis direction) to pass through the first pixel circuit PC1 and the second pixel circuit PC2. The scan line GWL may pass through pixel circuits arranged in a same row as the first pixel circuit PC1 and the second pixel circuit PC2.

The tenth conductive pattern 1710 may have an isolated shape and may extend in the first direction (e.g., the x-axis direction) to pass through the first pixel circuit PC1 and the second pixel circuit PC2. The tenth conductive pattern 1710 may intersect the imaginary line IML between the first pixel circuit PC1 and the second pixel circuit PC2.

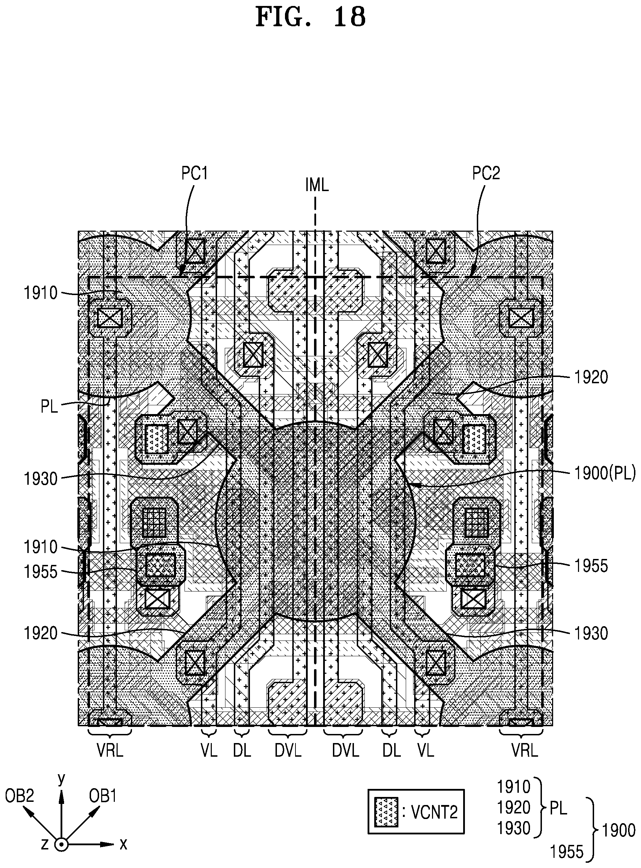

The tenth conductive pattern 1710 may be electrically connected to the second conductive pattern 1320 and the third oxide semiconductor pattern 1530 through contact holes CNT'. The tenth conductive pattern 1710 may be electrically connected to the fifth semiconductor layer A5 of the fifth transistor T5 (see FIG. 15) through a contact hole CNT'. The tenth conductive pattern 1710 may be a connection electrode that transmits the driving voltage ELVDD (see FIG. 8) of a driving voltage line PL (see FIG. 18) to be described below to the fifth transistor T5 (see FIG. 15). Likewise, the tenth conductive pattern 1710 may be a connection electrode that may be electrically connected to each of the first lower hold electrode CEh1a and the first upper hold electrode CEh1b, and the tenth conductive pattern 1710 may transmit the driving voltage of the driving voltage line PL (see FIG. 18) to the first hold electrode CEh1 (see FIG. 8) of the hold capacitor Chd (see FIG. 8).

The eleventh conductive pattern 1720 located in each of the first pixel circuit PC1 and the second pixel circuit PC2 may have an isolated shape. The eleventh conductive pattern 1720 may electrically connect the first transistor T1 (see FIG. 15) and the fifth transistor T5 (see FIG. 15) of each of the first pixel circuit PC1 and the second pixel circuit PC2. The eleventh conductive pattern 1720 may be electrically connected to the first semiconductor layer A1 of the first transistor T1 (see FIG. 15) through a contact hole CNT' and may be electrically connected to the fifth semiconductor layer A5 of the fifth transistor T5 (see FIG. 15) through a contact hole CNT'. For example, the eleventh conductive pattern 1720 may be a connection electrode connecting the first transistor T1 (see FIG. 15) to the fifth transistor T5 (see FIG. 15).

The twelfth conductive pattern 1730 located in each of the first pixel circuit PC1 and the second pixel circuit PC2 may have an isolated shape. The twelfth conductive pattern 1730 may correspond to the first node described with reference to FIG. 8. The twelfth conductive pattern 1730 may electrically connect the first transistor T1 (see FIG. 15), the third transistor T3 (see FIG. 15), and the first storage electrode CEs1 (see FIG. 12) of the storage capacitor Cst (see FIG. 15) of each of the first pixel circuit PC1 and the second pixel circuit PC2. The twelfth conductive pattern 1730 may be electrically connected to the sixth conductive pattern 1610 corresponding to the first gate electrode of the first transistor T1 (see FIG. 15) through a contact hole CNT', may be electrically connected to the third semiconductor layer A3 through a contact hole CNT', and may be electrically connected to the third conductive pattern 1330 through a contact hole CNT'.

The thirteenth conductive pattern 1740 located in each of the first pixel circuit PC1 and the second pixel circuit PC2 may have an isolated shape. The thirteenth conductive pattern 1740 may correspond to the second node described with reference to FIG. 8. The thirteenth conductive pattern 1740 may electrically connect the second storage electrode CEs2 (see FIG. 13), the second hold electrode CEh2 (see FIG. 13), the first transistor T1 (see FIG. 15), and the sixth transistor T6 (see FIG. 15). The thirteenth conductive pattern 1740 may be electrically connected to the fifth conductive pattern 1410 including the second storage electrode CEs2 (see FIG. 13) and the second hold electrode CEh2 (see FIG. 13) through a contact hole CNT', and may be electrically connected to the first oxide semiconductor pattern 1510 through a contact hole CNT'. A connection point between the thirteenth conductive pattern 1740 and the first oxide semiconductor pattern 1510 may be located between a region corresponding to the first semiconductor layer A1 and a region corresponding to the sixth semiconductor layer A6 (see FIG. 15) in the first oxide semiconductor pattern 1510.

The fourteenth conductive pattern 1750 located in each of the first pixel circuit PC1 and the second pixel circuit PC2 may have an isolated shape. The fourteenth conductive pattern 1750 may be electrically connected to the third transistor T3 (see FIG. 15). The fourteenth conductive pattern 1750 may be electrically connected to the third semiconductor layer A3 through a contact hole CNT'. The fourteenth conductive pattern 1750 may be a connection electrode connected to a reference voltage line VRL (see FIG. 17) to be described below and transmitting a reference voltage VREF (see FIG. 8) to the third transistor T3 (see FIG. 15).

The fifteenth conductive pattern 1760 located in each of the first pixel circuit PC1 and the second pixel circuit PC2 may have an isolated shape. The fifteenth conductive pattern 1760 may be electrically connected to the second transistor T2 (see FIG. 15). The fifteenth conductive pattern 1760 may be electrically connected to the second transistor T2 (see FIG. 15) through a contact hole CNT'. The fifteenth conductive pattern 1760 may be a connection electrode connected to a data line DL (see FIG. 17) to be described below and transmitting a data signal DATA (see FIG. 8) to the second transistor T2 (see FIG. 15).

The sixteenth conductive pattern 1770 located in the second pixel circuit PC2 may have an isolated shape. The sixteenth conductive pattern 1770 may electrically connect the fourth transistor T4 (see FIG. 15) of the second pixel circuit PC2 to the initialization voltage line VL to be described below with reference to FIG. 17. The sixteenth conductive pattern 1770 may be electrically connected to the fourth semiconductor layer A4 of the fourth transistor T4 (see FIG. 15) through a contact hole CNT'.

The fourth transistor T4 located in the first pixel circuit PC1 may be electrically connected to an initialization voltage line (not shown) passing through a pixel circuit adjacent to the first pixel circuit PC1. For example, a portion of the first oxide semiconductor pattern 1510 of the first pixel circuit PC1 may extend to an adjacent pixel circuit arranged in the (i)-th row and the (j-1)-th column, and the first oxide semiconductor pattern 1510 of the first pixel circuit PC1 may be electrically connected to an initialization voltage line passing through the adjacent pixel circuit.

A dummy conductive pattern 1770' located in the first pixel circuit PC1 may have an isolated shape. The dummy conductive pattern 1770' may be electrically connected to the fourth oxide semiconductor pattern 1540 through a contact hole CNT'.

The seventeenth conductive pattern 1780 located in each of the first pixel circuit PC1 and the second pixel circuit PC2 may have an isolated shape. The seventeenth conductive pattern 1780 may be electrically connected to the sixth transistor T6 (see FIG. 15). The seventeenth conductive pattern 1780 may be electrically connected to the sixth semiconductor layer A6 and the fourth semiconductor layer A4 through a contact hole CNT'. The seventeenth conductive pattern 1780 may be electrically connected to the first oxide semiconductor pattern 1510 through a contact hole CNT', and a connection point between the seventeenth conductive pattern 1780 and the first oxide semiconductor pattern 1510 may be located between a region corresponding to the sixth semiconductor layer A6 and a region corresponding to the fourth semiconductor layer A4 in the first oxide semiconductor pattern 1510. The seventeenth conductive pattern 1780 may be a connection electrode connecting the pixel electrode of the light-emitting diode LED (see FIG. 8), the fourth transistor T4 (see FIG. 15), and the sixth transistor T6 (FIG. 15).

Referring to FIG. 17, a fifth conductive layer 1800 may be arranged on the fourth conductive layer 1700. The fifth conductive layer 1800 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials.

The fifth conductive layer 1800 may include a data line DL, a data connection line DVL, an initialization voltage line VL, a reference voltage line VRL, an eighteenth conductive pattern 1810, and a nineteenth conductive pattern 1820. The data line DL, the data connection line DVL, the initialization voltage line VL, the reference voltage line VRL, the eighteenth conductive pattern 1810, and the nineteenth conductive pattern 1820 may be arranged to be spaced apart from each other.

Referring to FIG. 17, each of the data line DL, the data connection line DVL, the initialization voltage line VL, and the reference voltage line VRL may extend in the second direction (e.g., the y-axis direction). The data line DL, the data connection line DVL, the initialization voltage line VL, and the reference voltage line VRL passing through the first pixel circuit PC1 may be substantially symmetrical with the data line DL, the first data connection line DVL, the initialization voltage line VL, and the reference voltage line VRL passing through the second pixel circuit PC2 with respect to the imaginary line IML.

The data line DL passing through each of the first pixel circuit PC1 and the second pixel circuit PC2 may be electrically connected to the fifteenth conductive pattern 1760 described with reference to FIG. 16 through a first via contact hole VCNT1, and may provide a data signal to the second transistor T2 (see FIG. 15).

The data connection line DVL passing through each of the first pixel circuit PC1 and the second pixel circuit PC2 may be electrically connected to pixel circuits arranged in a different column from the first pixel circuit PC1 and the second pixel circuit PC2.

The initialization voltage line VL passing through the second pixel circuit PC2 may be electrically connected to the sixteenth conductive pattern 1770 (see FIG. 16) located in the second pixel circuit PC2 through a first via contact hole VCNT1 and provide an initialization voltage to the fourth transistor T4 (see FIG. 15) of the second pixel circuit PC2.

The initialization voltage line VL passing through the first pixel circuit PC1 may be electrically connected to the dummy conductive pattern 1770' described with reference to FIG. 16 through a first via contact hole VCNT1. As described above with reference to FIG. 16, the fourth transistor T4 (see FIG. 15) located in the first pixel circuit PC1 may be electrically connected to an initialization voltage line (not shown) passing through an adjacent pixel circuit adjacent to the first pixel circuit PC1.

The reference voltage line VRL passing through each of the first pixel circuit PC1 and the second pixel circuit PC2 may be electrically connected to the fourteenth conductive pattern 1750 described with reference to FIG. 16 through a first via contact hole VCNT1, and may provide a reference voltage to the third transistor T3 (see FIG. 15).

The eighteenth conductive pattern 1810 and the nineteenth conductive pattern 1820 may each have an isolated shape. The eighteenth conductive pattern 1810 located in each of the first pixel circuit PC1 and the second pixel circuit PC2 may be electrically connected to the tenth conductive pattern 1710 described with reference to FIG. 16 through a first via contact hole VCNT1. The tenth conductive pattern 1710 and the eighteenth conductive pattern 1810 may be connection electrodes that transfer the driving voltage ELVDD (see FIG. 8) of the driving voltage line PL (see FIG. 18) to be described below to the hold capacitor Chd (see FIG. 8).

The nineteenth conductive pattern 1820 located in each of the first pixel circuit PC1 and the second pixel circuit PC2 may be electrically connected to the seventeenth conductive pattern 1780 described with reference to FIG. 16 through a first via contact hole VCNT1. The seventeenth conductive pattern 1780 and the nineteenth conductive pattern 1820 may be connection electrodes that connect the pixel electrode of the light-emitting diode LED (see FIG. 8) to the fourth transistor T4 (see FIG. 15) and the sixth transistor T6 (see FIG. 15).

Referring to FIG. 18, a sixth conductive layer 1900 may be arranged on the fifth conductive layer 1800. The sixth conductive layer 1900 may include one or more materials selected from aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu) or a combination thereof.

The sixth conductive layer 1900 may include a driving voltage line PL and a twentieth conductive pattern 1955. The driving voltage line PL and the twentieth conductive pattern 1955 may be arranged to be spaced apart from each other.

The driving voltage line PL may include main parts 1910 that may be apart from each other, and bridge parts 1920 and 1930 that connect the main parts 1910. The main parts 1910 and the bridge parts 1920 and 1930 may be integral with each other. The connection structure of the main parts 1910 and the bridge parts 1920 and 1930 may have a mesh shape in a schematic plan view.

The main parts 1910 may overlap a voltage line or a signal line below the main parts 1910 in a third direction (e.g., the z-axis direction). In an embodiment, one of the main parts 1910 may be located on the imaginary line IML and may overlap a data line DL and a data connection line DVL that pass through each of the first pixel circuit PC1 and the second pixel circuit PC2. Another one of the main parts 1910 may overlap a reference voltage line VRL passing through the first pixel circuit PC1. Another one of the main parts 1910 may overlap a reference voltage line VRL passing through the second pixel circuit PC2. In an embodiment, the main part 1910 may also overlap an emission area of the light-emitting diode LED (see FIG. 8).

The bridge parts 1920 and 1930 may extend in a first diagonal direction OB1 and/or a second diagonal direction OB2 intersecting the first direction (e.g., the x-axis direction) and the second direction (e.g., the y-axis direction). Each of the bridge parts 1920 and 1930 may connect adjacent main parts 1910. In an embodiment, the first bridge part 1920 among the bridge parts 1920 and 1930 may extend in the first diagonal direction OB1 and be integral with two adjacent main parts 1910. The second bridge part 1930 among the bridge parts 1920 and 1930 may extend in the second diagonal direction OB2 and be integral with two adjacent main parts 1910.

In some embodiments, the driving voltage line PL may be electrically connected to a transistor or a capacitor through the bridge parts 1920 and 1930. For example, the second bridge part 1930 passing through the first pixel circuit PC1 may be electrically connected to the eighteenth conductive pattern 1810 (see FIG. 17) located in the first pixel circuit PC1 through a second via contact hole VCNT2. The eighteenth conductive pattern 1810 (see FIG. 17) may be electrically connected to the tenth conductive pattern 1710 (see FIG. 16) located in the first pixel circuit PC1. The tenth conductive pattern 1710 (see FIG. 16) may be electrically connected to the second conductive pattern 1320 (see FIG. 12) including the first lower hold electrode CEh1a (see FIG. 12) of the hold capacitor Chd (see FIG. 8), the third oxide semiconductor pattern 1530 (see FIG. 14) including the first upper hold electrode CEh1b (see FIG. 14) of the hold capacitor Chd (see FIG. 8), and the fifth semiconductor layer A5 (see FIG. 11) of the fifth transistor T5 (see FIG. 12). Therefore, the driving voltage of the driving voltage line PL may be transmitted to the fifth transistor T5 (see FIG. 12) of the first pixel circuit PC1 and the first hold electrode CEh1 (see FIG. 8) of the hold capacitor Chd (see FIG. 8).

The twentieth conductive pattern 1955 may have an isolated shape. The twentieth conductive pattern 1955 located in each of the first pixel circuit PC1 and the second pixel circuit PC2 may be electrically connected to the nineteenth conductive pattern 1820 (see FIG. 17) located in each of the first pixel circuit PC1 and the second pixel circuit PC2 through a second via contact hole VCNT2. The seventeenth conductive pattern 1780 (see FIG. 16), the nineteenth conductive pattern 1820 (see FIG. 17), and the twentieth conductive pattern 1955 may be connection electrodes that connect the pixel electrode of the light-emitting diode LED (see FIG. 8) to the fourth transistor T4 (see FIG. 15) and the sixth transistor T6 (see FIG. 15).

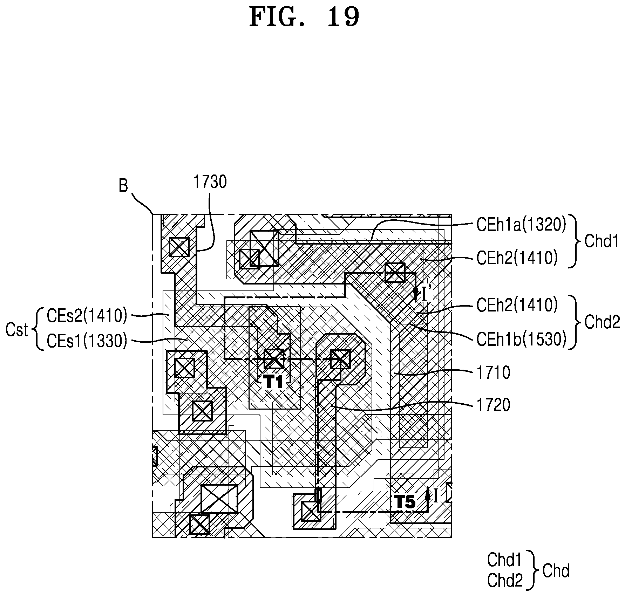

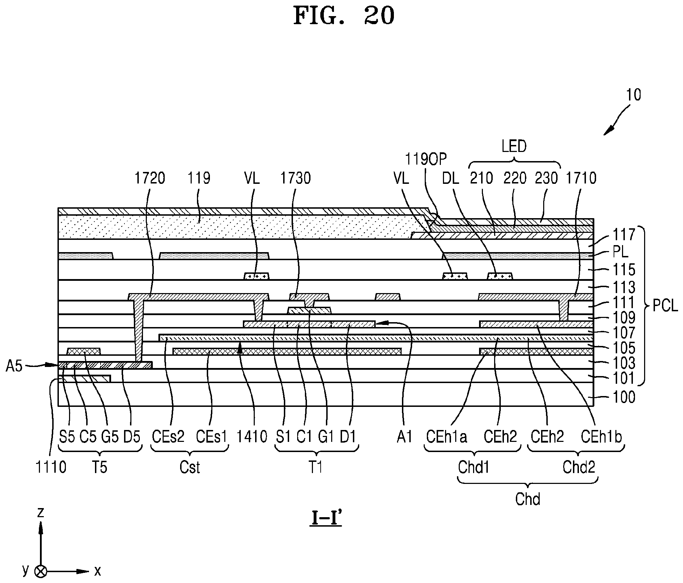

FIG. 19 is an enlarged schematic plan view of an area B of FIG. 9, which is a portion of a display panel according to an embodiment. FIG. 20 is a schematic cross-sectional view of a display panel 10 according to an embodiment, which shows a schematic cross-sectional view along line I-I' of FIG. 19. For convenience of description, FIG. 19 illustrates a structure in which the lower metal layer 1110 (see FIG. 10), the silicon semiconductor layer 1200 (see FIG. 11), the first conductive layer 1300 (see FIG. 12), the second conductive layer 1400 (see FIG. 13), the oxide semiconductor layer 1500 (see FIG. 14), the third conductive layer 1600 (see FIG. 15), and the fourth conductive layer 1700 (see FIG. 16) are stacked each other.

First, referring to FIG. 20, the display panel 10 may include a pixel circuit layer PCL including transistors and capacitors arranged on a substrate 100, and a display element layer arranged on the pixel circuit layer PCL and including a light-emitting diode LED. The pixel circuit layer PCL may include the transistors and capacitors described above with reference to FIGS. 8 to 18, and FIG. 20 illustrates the first transistor T1 and the fifth transistor T5, the storage capacitor Cst, and the hold capacitor Chd.

The substrate 100 may include a glass material, a ceramic material, a metal material, a plastic material, or a material that is flexible or bendable. In case that the substrate 100 is flexible or bendable, the substrate 100 may include a polymer resin, such as polyethersulfone (PES), polyacrylate, polyether imide (PEI), polyethylene naphthalate (PEN), polyethylene terephthalate (PET), polyphenylene sulfide (PPS), polyarylate, polyimide (PI), polycarbonate, or cellulose acetate propionate (CAP) or a combination thereof.

The substrate 100 may have a single-layer or multi-layer structure of the material, and in the case of a multi-layer structure, the substrate 100 may further include an inorganic layer. For example, the substrate 100 may have a structure in which a layer including the aforementioned polymer resin and a barrier layer including an inorganic insulating material may be alternately stacked each other.

A lower metal layer 1110 may be arranged on the substrate 100. As described above, the lower metal layer 1110 may include one or more materials selected from aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and copper (Cu) or a combination thereof. In some embodiments, the lower metal layer 1110 may be a single layer including molybdenum, may have a double layer structure in which a molybdenum layer and a titanium layer may be stacked each other, or may have a triple layer structure in which a titanium layer, an aluminum layer, and a titanium layer may be stacked each other.

The lower metal layer 1110 may have a voltage level of a constant voltage. For example, the lower metal layer 1110 and the driving voltage line PL described with reference to FIG. 8 may have a same voltage level (e.g., the driving voltage ELVDD). The lower metal layer 1110 may shield light traveling to the fifth semiconductor layer A5 of the fifth transistor T5 and may protect the fifth transistor T5 from static electricity.

The lower metal layer 1110 may be electrically connected to a portion of the driving voltage line PL (see FIG. 6) or the first power supply line 15 (see FIG. 6) in an area other than the display area DA (see FIG. 6), for example, the peripheral area PA (see FIG. 6).

A buffer layer 101 may be arranged on the lower metal layer 1110. The buffer layer 101 may be an inorganic insulating layer including an inorganic insulating material, such as silicon nitride and/or silicon oxide, and may have a single-layer or multi-layer structure including the aforementioned material.

A transistor including a silicon semiconductor layer may be arranged on the buffer layer 101. In this regard, FIG. 20 illustrates the fifth semiconductor layer A5 of the fifth transistor T5. The fifth semiconductor layer A5 may be a region included in the silicon semiconductor layer 1200 (see FIG. 11) and may be a silicon semiconductor layer including polysilicon. The fifth semiconductor layer A5 may include a channel region C5 and doped regions S5 and D5 doped with impurities, which may be arranged on both sides of the channel region C5. An doped region S5 or D5 of the fifth semiconductor layer A5 may be a source and another doped region D5 or S5 may be a drain.

A first gate insulating layer 103 may be arranged on the fifth semiconductor layer A5. The first gate insulating layer 103 may be an inorganic insulating layer including an inorganic insulating material, such as silicon oxide, silicon nitride, and/or silicon oxynitride, and may have a single-layer or multi-layer structure including the aforementioned material.

A fifth gate electrode G5 may be arranged on the first gate insulating layer 103 and may overlap in a third direction (e.g., the z-axis direction) the channel region C5 of the fifth semiconductor layer A5. The first storage electrode CEs1 of the storage capacitor Cst and a sub-layer of the first hold electrode CEh1 of the hold capacitor Chd, for example, the first lower hold electrode CEh1a, may be arranged on a same layer as the fifth gate electrode G5, for example, the first gate insulating layer 103. The fifth gate electrode G5, the first storage electrode CEs1, and the first lower hold electrode CEh1a may be portions of the first conductive layer 1300 described with reference to FIG. 12.

The fifth gate electrode G5, the first storage electrode CEs1 of the storage capacitor Cst, and the first lower hold electrode CEh1a of the hold capacitor Chd may include a same material. The fifth gate electrode G5, the first storage electrode CEs1 of the storage capacitor Cst, and the first lower hold electrode CEh1a of the hold capacitor Chd may each include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials. In an embodiment, the fifth gate electrode G5, the first storage electrode CEs1 of the storage capacitor Cst, and the first lower hold electrode CEh1a of the hold capacitor Chd may each be a single layer including molybdenum.

A second gate insulating layer 105 may be arranged on the fifth gate electrode G5, the first storage electrode CEs1 of the storage capacitor Cst, and the first lower hold electrode CEh1a of the hold capacitor Chd. The second gate insulating layer 105 may be an inorganic insulating layer including an inorganic insulating material, such as silicon oxide, silicon nitride, and/or silicon oxynitride, and may have a single-layer or multi-layer structure including the aforementioned materials. In an embodiment, the second gate insulating layer 105 may include a different material from the first gate insulating layer 103. For example, the first gate insulating layer 103 may include silicon oxide, and the second gate insulating layer 105 may include silicon nitride.

The fifth conductive pattern 1410 may be arranged on the second gate insulating layer 105. The fifth conductive pattern 1410 may be a portion of the second conductive layer 1400 described with reference to FIG. 13. The fifth conductive pattern 1410 may overlap in a third direction (e.g., the z-axis direction) the first storage electrode CEs1 of the storage capacitor Cst and the first lower hold electrode CEh1a of the hold capacitor Chd. The fifth conductive pattern 1410 may include the second storage electrode CEs2 of the storage capacitor Cst and the second hold electrode CEh2 of the hold capacitor Chd. One portion of the fifth conductive pattern 1410 may be the second storage electrode CEs2 of the storage capacitor Cst, and another portion of the fifth conductive pattern 1410 may be the second hold electrode CEh2 of the hold capacitor Chd. In other words, the second storage electrode CEs2 of the storage capacitor Cst and the second hold electrode CEh2 of the hold capacitor Chd may be integral with each other.

The fifth conductive pattern 1410, for example, the second storage electrode CEs2 of the storage capacitor Cst and the second hold electrode CEh2 of the hold capacitor Chd, may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials. As an example, the fifth conductive pattern 1410 may be a single layer including molybdenum.

A first interlayer insulating layer 107 may be arranged on the fifth conductive pattern 1410. The first interlayer insulating layer 107 may be an inorganic insulating layer including an inorganic insulating material, such as silicon oxide, silicon nitride, and/or silicon oxynitride, and may have a single-layer or multi-layer structure including the aforementioned material. For example, the first interlayer insulating layer 107 may have a structure in which a layer including silicon oxide and a layer including silicon nitride may be stacked each other.

The first semiconductor layer A1 of the first transistor T1 may be arranged on the first interlayer insulating layer 107. The first semiconductor layer A1 of the first transistor T1 may include an oxide semiconductor, and the oxide semiconductor may be an oxide semiconductor including at least one element selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn) or a combination thereof. For example, the oxide semiconductor may include ITZO or IGZO.

The first semiconductor layer A1 may include a channel region C1 and conductive regions S1 and D1 arranged on both sides of the channel region C1. A conductive region S1 or D1 may be a source and another conductive region D1 or S1 may be a drain. The first semiconductor layer A1 may be arranged on a different layer from the fifth semiconductor layer A5 described above. The vertical distance from the substrate 100 to the first semiconductor layer A1 may be greater than the vertical distance from the substrate 100 to the fifth semiconductor layer A5. The first semiconductor layer A1 may be a portion of the first oxide semiconductor pattern 1510 described with reference to FIG. 14.

The first upper hold electrode CEh1b of the hold capacitor Chd and the first semiconductor layer A1 may be arranged on a same layer and may include a same material. For example, the first upper hold electrode CEh1b of the hold capacitor Chd may be arranged on the first interlayer insulating layer 107. The first upper hold electrode CEh1b may be the third oxide semiconductor pattern 1530 described with reference to FIG. 14. The third oxide semiconductor pattern 1530 may be conductive in its entirety to function as the first upper hold electrode CEh1b. For example, the third oxide semiconductor pattern 1530 may be a conductive region in which plasma treatment is performed in its entirety.

Specifically, the oxide semiconductor layer 1500 (see FIG. 14) may have a property in which the conductive characteristics change depending on the oxygen content. In particular, a metal oxide semiconductor, such as ITZO or IGZO, may have the characteristics of a conductor or a semiconductor by appropriately controlling the oxygen content. Oxide semiconductor may basically have the characteristics of a semiconductor, but in case that the oxygen content in the oxide semiconductor is reduced, the metallic properties may be strengthened and the oxide semiconductor may have the properties of a conductor. The plasma treatment described above may be used as a method for reducing the oxygen content in the oxide semiconductor. In case that plasma treatment is performed on the oxide semiconductor layer 1500 (see FIG. 14), the oxygen contained therein may be released and the resistance of the oxide semiconductor may be lowered, and thus, the oxide semiconductor may become conductive. For example, the oxygen content of the conductive third oxide semiconductor pattern 1530 may be less than the oxygen content of the channel region C1 of the first semiconductor layer A1.

Referring to FIGS. 19 and 20, the storage capacitor Cst may be formed using the first conductive layer 1300 (see FIG. 12) and the second conductive layer 1400 (see FIG. 13). Specifically, the storage capacitor Cst may be formed in an area where the third conductive pattern 1330 of the first conductive layer 1300 (see FIG. 12) and the fifth conductive pattern 1410 of the second conductive layer 1400 (see FIG. 13) overlap each other in a third direction (e.g., the z-axis direction). The third conductive pattern 1330 may be the first storage electrode CEs1 electrically connected to the first node N1 (see FIG. 8), and the fifth conductive pattern 1410 may be the second storage electrode CEs2 electrically connected to the second node N2 (see FIG. 8).

In an embodiment, the hold capacitor Chd may be formed using the first conductive layer 1300 (see FIG. 12), the second conductive layer 1400 (see FIG. 13), and the oxide semiconductor layer 1500 (see FIG. 14). Specifically, the hold capacitor Chd may include a first sub-hold capacitor Chd1 formed by overlapping of the first conductive layer 1300 (see FIG. 12) and the second conductive layer 1400 (see FIG. 13) in a third direction (e.g., the z-axis direction), and a second sub-hold capacitor Chd2 formed by overlapping of the second conductive layer 1400 (see FIG. 13) and the oxide semiconductor layer 1500 (see FIG. 14) in a third direction (e.g., the z-axis direction). The first sub-hold capacitor Chd1 may be formed in a region where the second conductive pattern 1320 of the first conductive layer 1300 (see FIG. 12) and the fifth conductive pattern 1410 of the second conductive layer 1400 (see FIG. 13) overlap each other in a third direction (e.g., the z-axis direction). The second sub-hold capacitor Chd2 may be formed in a region where the fifth conductive pattern 1410 of the second conductive layer 1400 (see FIG. 13) and the third oxide semiconductor pattern 1530 of the oxide semiconductor layer 1500 (see FIG. 14) overlap each other in a third direction (e.g., the z-axis direction). The second conductive pattern 1320 may be a first lower hold electrode CEh1a that may be a sub-layer of the first hold electrode CEh1 (see FIG. 8), and the third oxide semiconductor pattern 1530 may be a first upper hold electrode CEh1b that may be a sub-layer of the first hold electrode CEh1 (see FIG. 8). The fifth conductive pattern 1410 may be a second hold electrode CE2 that faces each of the first lower hold electrode CEh1a and the first upper hold electrode CEh1b. The second conductive pattern 1320, the fifth conductive pattern 1410, and the third oxide semiconductor pattern 1530 may be stacked each other to overlap each other in a third direction (e.g., the z-axis direction) to form the hold capacitor Chd.

The hold capacitor Chd may be formed to stabilize the voltage of the second node N2 (see FIG. 8), and a constant voltage may be applied to the first hold electrode CEh1 (see FIG. 8) of the hold capacitor Chd. For example, a constant voltage may be applied to each of the first lower hold electrode CEh1a and the first upper hold electrode CEh1b. In an embodiment, each of the first lower hold electrode CEh1a and the first upper hold electrode CEh1b may be electrically connected to the driving voltage line PL. For example, the first upper hold electrode CEh1b may be electrically connected to the driving voltage line PL through the tenth conductive pattern 1710 (see FIG. 16) and the eighteenth conductive pattern 1810 (see FIG. 17) to receive the driving voltage ELVDD (see FIG. 8). Likewise, the first lower hold electrode CEh1a may be electrically connected to the driving voltage line PL through the tenth conductive pattern 1710 (see FIG. 16) and the eighteenth conductive pattern 1810 (see FIG. 17) to receive the driving voltage ELVDD (see FIG. 8). In other words, the first lower hold electrode CEh1a and the first upper hold electrode CEh1b may be arranged on different layers, but may be electrically connected to each other to receive a same constant voltage.

By forming the hold capacitor Chd with the structure described above, the hold capacitor Chd of the display device according to an embodiment may have a high storage capacity. Specifically, compared to the case where the first sub-hold capacitor Chd1 is formed using the first conductive layer 1300 (see FIG. 12) and the second conductive layer 1400 (see FIG. 13), in case that the second sub-hold capacitor Chd2 is additionally formed in addition to the first sub-hold capacitor Chd1 by using the second conductive layer 1400 (see FIG. 13) and the oxide semiconductor layer 1500 (see FIG. 14), the capacity of the hold capacitor Chd may be significantly increased while using a same pixel circuit area. Accordingly, the display panel 10 according to an embodiment may maintain a high resolution, reduce the voltage change of the second node N2 (see FIG. 8) by increasing the capacity of the hold capacitor Chd, and drive the pixel circuit PC (see FIG. 8) more stably.

As described above, the second gate insulating layer 105 may be arranged between the first lower hold electrode CEh1a and the second hold electrode CEh2, and the first interlayer insulating layer 107 may be arranged between the second hold electrode CEh2 and the first upper hold electrode CEh1b. In an embodiment, as the thickness of the second gate insulating layer 105 is reduced, the storage capacity of the first sub-hold capacitor Chd1 may increase, and as the thickness of the first interlayer insulating layer 107 is reduced, the storage capacity of the second sub-hold capacitor Chd2 may increase.

For example, in case that the hold capacitor Chd has the first sub-hold capacitor Chd1 and the second sub-hold capacitor Chd2 and the thicknesses of the second gate insulating layer 105 and the first interlayer insulating layer 107 are each 500 Å, the capacitance of the hold capacitor Chd may increase by 30 fF compared to the case where the hold capacitor Chd has only the first sub-hold capacitor Chd1. In case that the hold capacitor Chd has the first sub-hold capacitor Chd1 and the second sub-hold capacitor Chd2, and the thicknesses of the second gate insulating layer 105 and the first interlayer insulating layer 107 are each 1000 Å, the capacitance of the hold capacitor Chd may increase by 15 fF compared to the case where the hold capacitor Chd has only the first sub-hold capacitor Chd1. Hence, a storage capacity of the hold capacitor Chd may be significantly increased based on additionally forming the second sub-hold capacitor Chd2 using the oxide semiconductor layer 1500 (see FIG. 14), and reducing the thickness of insulating layers arranged between the hold capacitors Chd.

Referring back to FIG. 20, a third gate insulating layer 109 may be arranged on the first semiconductor layer A1 and the first upper hold electrode CEh1b of the hold capacitor Chd. The third gate insulating layer 109 may be an inorganic insulating layer including an inorganic insulating material, such as silicon oxide, silicon nitride, and/or silicon oxynitride, and may have a single-layer or multi-layer structure including the aforementioned material. In an embodiment, the third gate insulating layer 109 may be a single layer including silicon oxide.

FIG. 20 illustrates that the third gate insulating layer 109 may pass through the side surface of the first semiconductor layer A1 and may contact the upper surface of the first interlayer insulating layer 107. However, embodiments of the disclosure are not limited thereto. In another embodiment, the third gate insulating layer 109 and the first gate electrode G1 may be formed to have substantially a same pattern and/or a same width, described below. In other words, the third gate insulating layer 109 may not pass through the side surface of the first semiconductor layer A1 and contact the upper surface of the first interlayer insulating layer 107.

The first gate electrode G1 may be arranged on the third gate insulating layer 109. The first gate electrode G1 may overlap in a third direction (e.g., the z-axis direction) the channel region C1 of the first semiconductor layer A1. The first gate electrode G1 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials. In an embodiment, the first gate electrode G1 may have a three-layer structure of titanium layer/aluminum layer/titanium layer.

The second interlayer insulating layer 111 may be arranged on the first gate electrode G1. The second interlayer insulating layer 111 may be an inorganic insulating layer including an inorganic insulating material, such as silicon oxide, silicon nitride, and/or silicon oxynitride, and may have a single-layer or multi-layer structure including the aforementioned materials. In an embodiment, the second interlayer insulating layer 111 may have a structure in which a layer including silicon nitride and a layer including silicon oxynitride may be stacked each other.

The tenth conductive pattern 1710, the eleventh conductive pattern 1720, and the twelfth conductive pattern 1730 may be arranged on a same layer, for example, the second interlayer insulating layer 111. The tenth conductive pattern 1710, the eleventh conductive pattern 1720, and the twelfth conductive pattern 1730 may include a same material. The tenth conductive pattern 1710, the eleventh conductive pattern 1720, and the twelfth conductive pattern 1730 may each include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials. In an embodiment, the tenth conductive pattern 1710, the eleventh conductive pattern 1720, and the twelfth conductive pattern 1730 may have a three-layer structure of titanium layer/aluminum layer/titanium layer. The tenth conductive pattern 1710, the eleventh conductive pattern 1720, and the twelfth conductive pattern 1730 may be portions of the fourth conductive layer 1700 described with reference to FIG. 16.

A first organic insulating layer 113 may be arranged on the tenth conductive pattern 1710, the eleventh conductive pattern 1720, and the twelfth conductive pattern 1730. The first organic insulating layer 113 may include an organic insulating material, such as acrylic, benzocyclobutene (BCB), polyimide, or hexamethyldisiloxane (HMDSO) or a combination thereof.

The data line DL and the initialization voltage line VL may be arranged on the first organic insulating layer 113. The data line DL and the initialization voltage line VL may each include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials. In an embodiment, the data line DL and the initialization voltage line VL may each have a three-layer structure of titanium layer/aluminum layer/titanium layer. The data line DL and the initialization voltage line VL may be portions of the fifth conductive layer 1800 described with reference to FIG. 17.

A second organic insulating layer 115 may be arranged on the data line DL and the initialization voltage line VL. The second organic insulating layer 115 may include an organic insulating material, such as acrylic, BCB, polyimide, or HMDSO or a combination thereof.

A driving voltage line PL may be arranged on the second organic insulating layer 115. The driving voltage line PL may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu) or a combination thereof, and may include a single layer or multiple layers including the aforementioned materials. In an embodiment, the driving voltage line PL may have a three-layer structure of titanium layer/aluminum layer/titanium layer. The driving voltage line PL may be a portion of the sixth conductive layer 1900 described with reference to FIG. 18.

A third organic insulating layer 117 may be arranged on the driving voltage line PL. The third organic insulating layer 117 may include an organic insulating material, such as acrylic, BCB, polyimide, or HMDSO or a combination thereof.

A light-emitting diode LED may be arranged on the third organic insulating layer 117. The light-emitting diode LED may include a pixel electrode 210, an intermediate layer 220, and an opposite electrode 230 on the third organic insulating layer 117.

An outer portion of the pixel electrode 210 may be covered by a bank layer 119 in a third direction (e.g., the z-axis direction), and an inner portion of the pixel electrode 210 may overlap in a third direction (e.g., the z-axis direction) the intermediate layer 220 through an opening 119OP of the bank layer 119. The pixel electrode 210 may be arranged to correspond to each light-emitting diode LED, and the opposite electrode 230 may be arranged to correspond to light-emitting diodes LED. In other words, the opposite electrode 230 may extend to overlap pixel electrodes 210 in a third direction (e.g., the z-axis direction). The light-emitting diodes LED may share the opposite electrode 230, and a stacked structure of the pixel electrode 210, the intermediate layer 220, and the opposite electrode 230 may correspond to a light-emitting diode LED.

The intermediate layer 220 may include an emission layer. In some embodiments, the intermediate layer 220 may further include an emission layer and a functional layer. The functional layer may include a hole transport layer (HTL), a hole injection layer (HIL), an electron transport layer (ETL), and/or an electron injection layer (EIL). In some other embodiments, the intermediate layer 220 may include a first stack including an emission layer and a functional layer, a second stack including an emission layer and a functional layer, and a charge generation layer between the first stack and the second stack. The charge generation layer may include a negative charge generation layer and a positive charge generation layer. The emission efficiency of a tandem type light-emitting diode LED having a emission layers may be further increased by the negative charge generation layer and the positive charge generation layer.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

The opposite electrode 230 may include a conductive material having a low work function. The opposite electrode 230 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. In another example, the opposite electrode 230 may further include a layer including a material, such as ITO, IZO, ZnO or In2O3, on the (semi)transparent layer including the aforementioned material.

Although not illustrated in the drawings, an encapsulation layer may be arranged on the light-emitting diode LED. The encapsulation layer may include a first inorganic encapsulation layer, a second inorganic encapsulation layer, and an organic encapsulation layer between the first organic encapsulation layer and the second inorganic encapsulation layer.

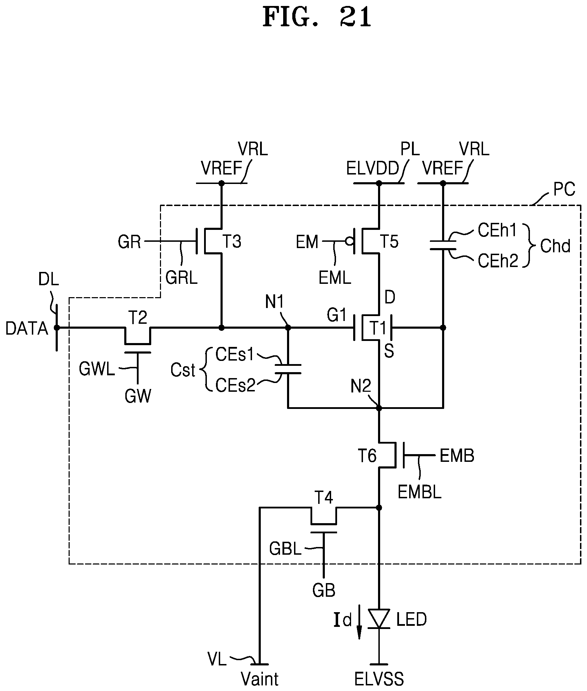

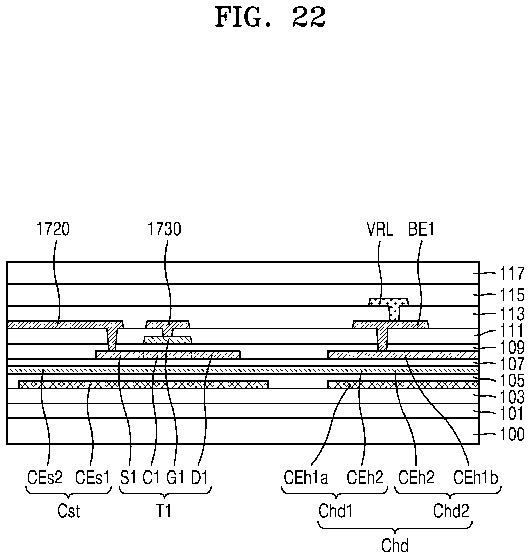

FIG. 21 is a schematic diagram of an equivalent circuit of a light-emitting diode and a pixel circuit of a display panel according to another embodiment, and FIG. 22 is a schematic cross-sectional view of a display panel according to another embodiment. Referring to FIGS. 21 and 22, except for the features of a hold capacitor Chd, other features are as described with reference to FIGS. 8 to 20. In FIGS. 21 and 22, the same reference numerals and/or reference characters as those in FIGS. 8 to 20 denote the same members as those in FIGS. 8 to 20, and thus, the differences will be described below.

Referring to FIG. 21, a pixel circuit PC electrically connected to a light-emitting diode LED may include transistors and capacitors. In an embodiment, the pixel circuit PC may include first to sixth transistors T1, T2, T3, T4, T5, and T6, a storage capacitor Cst, and a hold capacitor Chd.

In an embodiment, the hold capacitor Chd may be electrically connected between a reference voltage line VRL and a second node N2. A first hold electrode CEh1 of the hold capacitor Chd may be electrically connected to the reference voltage line VRL, and a second hold electrode CEh2 of the hold capacitor Chd may be electrically connected to the second node N2. The hold capacitor Chd may allow the voltage of the lower gate electrode of the first transistor T1 and the second node N2 to remain constant and not fluctuate even in case that a peripheral signal fluctuates.

Referring to FIG. 22, transistors and capacitors may be arranged on a substrate 100. FIG. 22 illustrates the first transistor T1, the storage capacitor Cst, and the hold capacitor Chd for convenience of description.

On a first gate insulating layer 103, a first storage electrode CEs1 of the storage capacitor Cst and a first lower hold electrode CEh1a that is a sub-layer of the first hold electrode CEh1 of the hold capacitor Chd may be arranged. A second gate insulating layer 105 may be arranged on the first storage electrode CEs1 and the first lower hold electrode CEh1a, and a second conductive layer 1400 (see FIG. 13) may be arranged on the second gate insulating layer 105. The second conductive layer 1400 (see FIG. 13) may include a second storage electrode CEs2 overlapping the first storage electrode CEs1 in a third direction (e.g., the z-axis direction) and a second hold electrode CEh2 overlapping the first lower hold electrode CEh1a in a third direction (e.g., the z-axis direction). The second storage electrode CEs2 and the second hold electrode CEh2 may be integral with each other.

A first interlayer insulating layer 107 may be arranged on the second storage electrode CEs2 and the second hold electrode CEh2, and an oxide semiconductor layer 1500 (see FIG. 14) may be arranged on the first interlayer insulating layer 107. The oxide semiconductor layer 1500 (see FIG. 14) may include a channel region C1 of the first transistor T1 and conductive regions S1 and D1 on both sides of the channel region C1. The oxide semiconductor layer 1500 (see FIG. 14) may include a first upper hold electrode CEh1b that is a sub-layer of the first hold electrode CEh1 of the hold capacitor Chd. The first upper hold electrode CEh1b may overlap the second hold electrode CEh2 in a third direction (e.g., the z-axis direction). The first upper hold electrode CEh1b may be a conductive portion of the oxide semiconductor layer 1500 (see FIG. 14).

Hence, the storage capacitor Cst may be formed by overlapping in a third direction (e.g., the z-axis direction) of the first storage electrode CEs1 arranged in the first conductive layer 1300 (see FIG. 12) and the second storage electrode CEs2 arranged in the second conductive layer 1400 (see FIG. 13). The hold capacitor Chd may include a first sub-hold capacitor Chd1 and a second sub-hold capacitor Chd2 arranged to overlap each other in a third direction (e.g., the z-axis direction). The first sub-hold capacitor Chd1 may be formed by overlapping in a third direction (e.g., the z-axis direction) of the first lower hold electrode CEh1a arranged in the first conductive layer 1300 (see FIG. 12) and the second hold electrode CEh2 arranged in the second conductive layer 1400 (see FIG. 13). The second sub-hold capacitor Chd2 may be formed by overlapping in a third direction (e.g., the z-axis direction) of the second hold electrode CEh2 arranged in the second conductive layer 1400 (see FIG. 13) and the first upper hold electrode CEh1b arranged in the oxide semiconductor layer 1500 (see FIG. 14).

The hold capacitor Chd may be formed to stabilize the voltage of a second node N2, and a constant voltage may be applied to the first hold electrode CEh1 of the hold capacitor Chd. For example, a constant voltage may be applied to each of the first lower hold electrode CEh1a and the first upper hold electrode CEh1b. In an embodiment, each of the first lower hold electrode CEh1a and the first upper hold electrode CEh1b may be electrically connected to the reference voltage line VRL. For example, as shown in FIG. 22, the first upper hold electrode CEh1b may be electrically connected, through a first bridge electrode BE1, to the reference voltage line VRL arranged in the fifth conductive layer 1800 (see FIG. 17) and receive the reference voltage VREF. In FIG. 22, the structure in which the first lower hold electrode CEh1a and the reference voltage line VRL are electrically connected to each other is not shown, but the first lower hold electrode CEh1a may also be electrically connected to the reference voltage line VRL through bridge electrodes and receive the reference voltage VREF.

By forming the hold capacitor Chd with the structure described above, the hold capacitor Chd of the display device according to an embodiment may have a high storage capacity. Specifically, compared to the case where only the first sub-hold capacitor Chd1 is formed using the first conductive layer 1300 (see FIG. 12) and the second conductive layer 1400 (see FIG. 13), in case that the second sub-hold capacitor Chd2 is additionally formed in addition to the first sub-hold capacitor Chd1 by using the second conductive layer 1400 (see FIG. 13) and the oxide semiconductor layer 1500 (see FIG. 14), the capacity of the hold capacitor Chd may be significantly increased while using a same pixel circuit area. Accordingly, the display panel 10 according to an embodiment may maintain a high resolution, reduce the voltage change of the second node N2 by increasing the capacity of the hold capacitor Chd, and drive the pixel circuit PC more stably.

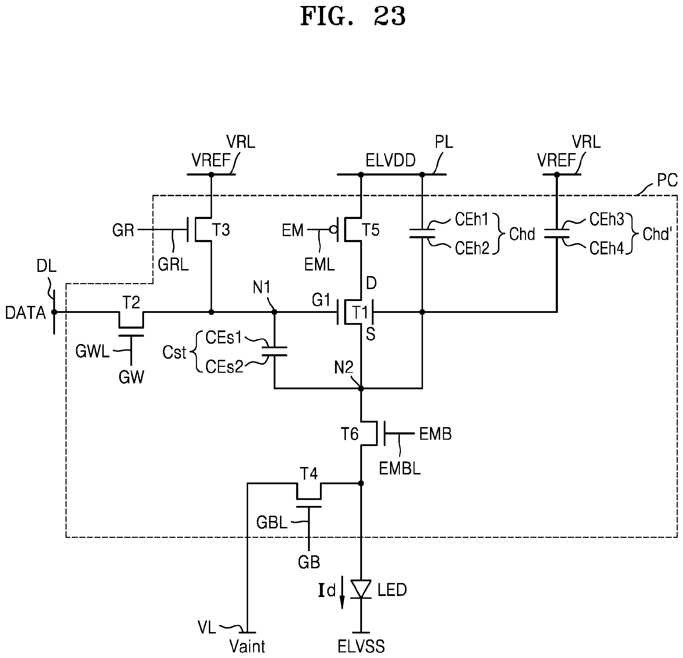

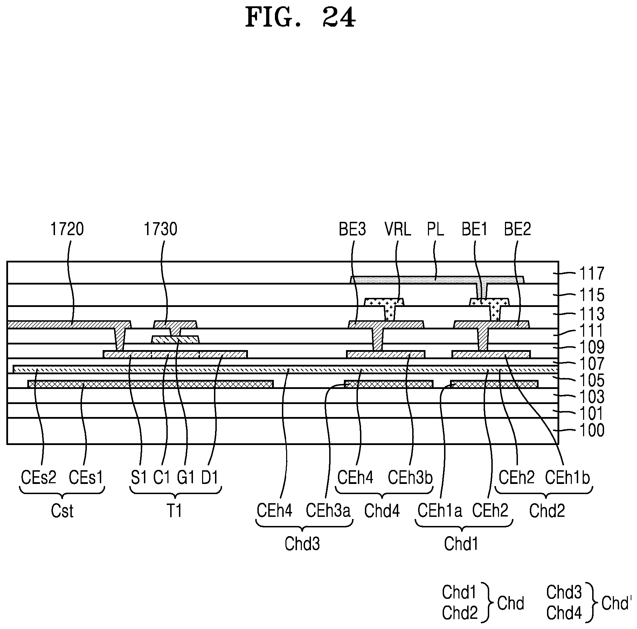

FIG. 23 is a schematic diagram of an equivalent circuit of a light-emitting diode and a pixel circuit of a display panel according to another embodiment, and FIG. 24 is a schematic cross-sectional view of a display panel according to another embodiment. Referring to FIGS. 23 and 24, except for the features of a hold capacitor Chd and an auxiliary hold capacitor Chd', the other features are as described with reference to FIGS. 8 to 20. In FIGS. 23 and 24, the same reference numerals and/or reference characters as those in FIGS. 8 to 20 denote the same members as those in FIGS. 8 to 20, and thus, the differences will be described below.

Referring to FIG. 23, a pixel circuit PC electrically connected to a light-emitting diode LED may include transistors and capacitors. In an embodiment, the pixel circuit PC may include first to sixth transistors T1, T2, T3, T4, T5, and T6, a storage capacitor Cst, a hold capacitor Chd, and an auxiliary hold capacitor Chd'.

In an embodiment, the hold capacitor Chd may be electrically connected between a driving voltage line PL and a second node N2. A first hold electrode CEh1 of the hold capacitor Chd may be electrically connected to the driving voltage line PL, and a second hold electrode CEh2 may be electrically connected to the second node N2. In an embodiment, the pixel circuit PC may further include the auxiliary hold capacitor Chd' in addition to the hold capacitor Chd. The auxiliary hold capacitor Chd' may be electrically connected between the lower gate electrode of the first transistor T1 and a reference voltage line VRL. A third hold electrode CEh3 of the auxiliary hold capacitor Chd' may be electrically connected to the reference voltage line VRL, and a fourth hold electrode CEh4 of the auxiliary hold capacitor Chd' may be electrically connected to the lower gate electrode of the first transistor T1 and the second node N2. The hold capacitor Chd and the auxiliary hold capacitor Chd' may allow the voltage of the lower gate electrode of the first transistor T1 and the second node N2 to remain constant and not fluctuate even when a peripheral signal fluctuates.

Referring to FIG. 24, transistors and capacitors may be arranged on a substrate 100. For convenience of description, FIG. 24 illustrates the first transistor T1, the storage capacitor Cst, the hold capacitor Chd, and the auxiliary hold capacitor Chd'.

On a first gate insulating layer 103, a first storage electrode CEs1 of the storage capacitor Cst, a first lower hold electrode CEh1a that is a sub-layer of the first hold electrode CEh1 of the hold capacitor Chd, and a third lower hold electrode CEh3a that is a sub-layer of the third hold electrode CEh3 of the auxiliary hold capacitor Chd' may be arranged. The first storage electrode CEs1, the first lower hold electrode CEh1a, and the third lower hold electrode CEh3a may be arranged on a same layer and may include a same material.

A second gate insulating layer 105 may be arranged on the first storage electrode CEs1, the first lower hold electrode CEh1a, and the third lower hold electrode CEh3a, and a second conductive layer 1400 (see FIG. 13) may be arranged on the second gate insulating layer 105. The second conductive layer 1400 (see FIG. 13) may include a second storage electrode CEs2 overlapping the first storage electrode CEs1 in a third direction (e.g., the z-axis direction), a second hold electrode CEh2 overlapping the first lower hold electrode CEh1a in a third direction (e.g., the z-axis direction), and a fourth hold electrode CEh4 overlapping the third lower hold electrode CEh3a in a third direction (e.g., the z-axis direction). The second storage electrode CEs2, the second hold electrode CEh2, and the fourth hold electrode CEh4 may be integral with each other.

A first interlayer insulating layer 107 may be arranged on the second storage electrode CEs2, the second hold electrode CEh2, and the fourth hold electrode CEh4, and an oxide semiconductor layer 1500 (see FIG. 14) may be arranged on the first interlayer insulating layer 107. The oxide semiconductor layer 1500 (see FIG. 14) may include a channel region C1 of the first transistor T1 and conductive regions S1 and D1 on both sides of the channel region C1. The oxide semiconductor layer 1500 (see FIG. 14) may include a first upper hold electrode CEh1b, which may be a sub-layer of the first hold electrode CEh1 of the hold capacitor Chd, and a third upper hold electrode CEh3b, which may be a sub-layer of the third hold electrode CEh3 of the auxiliary hold capacitor Chd'. The first upper hold electrode CEh1b may overlap the second hold electrode CEh2 in a third direction (e.g., the z-axis direction), and the third upper hold electrode CEh3b may overlap the fourth hold electrode CEh4 in a third direction (e.g., the z-axis direction). The first upper hold electrode CEh1b and the third upper hold electrode CEh3b may be conductive portions of the oxide semiconductor layer 1500 (see FIG. 14).

Hence, the storage capacitor Cst may be formed by overlapping in a third direction (e.g., the z-axis direction) of the first storage electrode CEs1 arranged in the first conductive layer 1300 (see FIG. 12) and the second storage electrode CEs2 arranged in the second conductive layer 1400 (see FIG. 13). The hold capacitor Chd may include a first sub-hold capacitor Chd1 and a second sub-hold capacitor Chd2 arranged to overlap each other in a third direction (e.g., the z-axis direction). The first sub-hold capacitor Chd1 may be formed by overlapping in a third direction (e.g., the z-axis direction) of the first lower hold electrode CEh1a arranged in the first conductive layer 1300 (see FIG. 12) and the second hold electrode CEh2 arranged in the second conductive layer 1400 (see FIG. 13). The second sub-hold capacitor Chd2 may be formed by overlapping in a third direction (e.g., the z-axis direction) of the second hold electrode CEh2 arranged on the second conductive layer 1400 (see FIG. 13) and the first upper hold electrode CEh1b arranged on the oxide semiconductor layer 1500 (see FIG. 14).

The auxiliary hold capacitor Chd' may include a third sub-hold capacitor Chd3 and a fourth sub-hold capacitor Chd4 arranged to overlap each other in a third direction (e.g., the z-axis direction). The third sub-hold capacitor Chd3 may be formed by overlapping in a third direction (e.g., the z-axis direction) of the third lower hold electrode CEh3a arranged in the first conductive layer 1300 (see FIG. 12) and the fourth hold electrode CEh4 arranged in the second conductive layer 1400 (see FIG. 13). The fourth sub-hold capacitor Chd4 may be formed by overlapping in a third direction (e.g., the z-axis direction) of the fourth hold electrode CEh4 arranged in the second conductive layer 1400 (see FIG. 13) and the third upper hold electrode CEh3b arranged in the oxide semiconductor layer 1500 (see FIG. 14).

The hold capacitor Chd and the auxiliary hold capacitor Chd' may be formed to stabilize the voltage of a second node N2, and a constant voltage may be applied to the first hold electrode CEh1 of the hold capacitor Chd and the third hold electrode CEh3 of the auxiliary hold capacitor Chd'. For example, a constant voltage may be applied to each of the first lower hold electrode CEh1a, the first upper hold electrode CEh1b, the third lower hold electrode CEh3a, and the third upper hold electrode CEh3b.

In an embodiment, each of the first lower hold electrode CEh1a and the first upper hold electrode CEh1b may be electrically connected to the driving voltage line PL. For example, as shown in FIG. 24, the first upper hold electrode CEh1b may be electrically connected, through a first bridge electrode BE1 and a second bridge electrode BE2, to the driving voltage line PL arranged in the sixth conductive layer 1900 (see FIG. 18) and receive the driving voltage ELVDD. In FIG. 24, the structure in which the first lower hold electrode CEh1b and the driving voltage line PL are electrically connected to each other is not shown, but the first lower hold electrode CEh1a may also be electrically connected to the driving voltage line PL through bridge electrodes and receive the driving voltage ELVDD.

Likewise, in an embodiment, each of the third lower hold electrode CEh3a and the third upper hold electrode CEh3b may be electrically connected to the reference voltage line VRL. For example, as shown in FIG. 24, the third upper hold electrode CEh3b may be electrically connected, through a third bridge electrode BE3, to the reference voltage line VRL arranged in the fifth conductive layer 1800 (see FIG. 17) and receive the reference voltage VREF. In FIG. 24, the structure in which the third lower hold electrode CEh3a and the reference voltage line VRL are electrically connected to each other is not shown, but the third lower hold electrode CEh3a may also be electrically connected to the reference voltage line VRL through bridge electrodes and receive the reference voltage VREF.

By forming the hold capacitor Chd and the auxiliary hold capacitor Chd' with the structure described above, the hold capacitor Chd and the auxiliary hold capacitor Chd' of the display device according to an embodiment may have a high storage capacity. In the case of the display device shown in FIG. 24, in addition to the hold capacitor Chd including the first sub-hold capacitor Chd1 and the second sub-hold capacitor Chd2, the auxiliary hold capacitor Chd' including the third sub-hold capacitor Chd3 and the fourth sub-hold capacitor Chd4 may be additionally arranged, and thus, the storage capacity of the capacitor may be significantly increased. Accordingly, the display panel 10 according to an embodiment may maintain a high resolution, reduce the voltage change of the second node N2 by increasing the capacity of the capacitor, and drive the pixel circuit PC more stably.

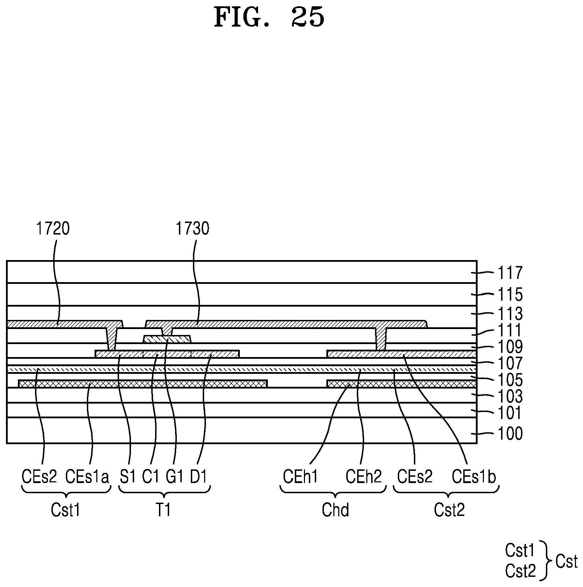

FIG. 25 is a schematic cross-sectional view of a display panel according to another embodiment. Referring to FIG. 25, except for the features of a storage capacitor Cst and a hold capacitor Chd, the other features are as described with reference to FIGS. 8 to 20. In FIG. 25, the same reference numerals and/or reference characters as those in FIGS. 8 to 20 denote the same members as those in FIGS. 8 to 20, and thus, the differences will be described below.

Referring to FIG. 25, transistors and capacitors may be arranged on a substrate 100. FIG. 25 illustrates the first transistor T1, the storage capacitor Cst, and the hold capacitor Chd for convenience of description.

In an embodiment, the storage capacitor Cst may include a first sub-storage capacitor Cst1 and a second sub-storage capacitor Cst2. Specifically, a first lower storage electrode CEs1a, which may be a sub-layer of the first storage electrode CEs1 (see FIG. 8) of the storage capacitor Cst, and a first hold electrode CEh1 of the hold capacitor Chd may be arranged on the first gate insulating layer 103. The first lower storage electrode CEs1a and the first hold electrode CEh1 may be portions of the first conductive layer 1300 (see FIG. 12) and may include a same material.

A second gate insulating layer 105 may be arranged on the first lower storage electrode CEs1a and the first hold electrode CEh1, and the second conductive layer 1400 (see FIG. 13) may be arranged on the second gate insulating layer 105. The second conductive layer 1400 (see FIG. 13) may include a second storage electrode CEs2 overlapping the first lower storage electrode CEs1a in a third direction (e.g., the z-axis direction) and a second hold electrode CEh2 overlapping the first hold electrode CEh1 in a third direction (e.g., the z-axis direction). The first hold electrode CEh1 and the second hold electrode CEh2 may be integral with each other.

A first interlayer insulating layer 107 may be arranged on the second storage electrode CEs2 and the second hold electrode CEh2, and the oxide semiconductor layer 1500 (see FIG. 14) may be arranged on the first interlayer insulating layer 107. The oxide semiconductor layer 1500 (see FIG. 14) may include a channel region C1 of the first transistor T1 and conductive regions S1 and D1 on both sides of the channel region C1. The oxide semiconductor layer 1500 (see FIG. 14) may include a first upper storage electrode CEs1b, which may be a sub-layer of the first storage electrode CEs1 (see FIG. 8) of the storage capacitor Cst. The first upper storage electrode CEs1b may be a conductive portion of the oxide semiconductor layer 1500 (see FIG. 14). A region of the second conductive layer 1400 (see FIG. 13), which overlaps the first upper storage electrode CEs1b in a third direction (e.g., the z-axis direction), may be another second storage electrode CEs2.

Hence, the hold capacitor Chd may be formed by overlapping in a third direction (e.g., the z-axis direction) of the first hold electrode CEh1 arranged in the first conductive layer 1300 (see FIG. 12) and the second hold electrode CEh2 arranged in the second conductive layer 1400 (see FIG. 13). The storage capacitor Cst can include a first sub-storage capacitor Cst1 and a second sub-storage capacitor Cst2. The first sub-storage capacitor Cst1 may be formed by overlapping in a third direction (e.g., the z-axis direction) of the first lower storage electrode CEs1a arranged in the first conductive layer 1300 (see FIG. 12) and the second storage electrode CEh2 arranged in the second conductive layer 1400 (see FIG. 13). The second sub-storage capacitor Cst2 may be formed by overlapping in a third direction (e.g., the z-axis direction) of the second storage electrode CEs2 arranged in the second conductive layer 1400 (see FIG. 13) and the first upper storage electrode CEs1b arranged in the oxide semiconductor layer 1500 (see FIG. 14).

In case that the storage capacitor Cst may be electrically connected between the first node N1 and the second node N2 and the second storage electrode CEs2 may be electrically connected to the second node N2, each of the first lower storage electrode CEs1a and the first upper storage electrode CEs1b may be electrically connected to the first node N1. Specifically, each of the first lower storage electrode CEs1a and the first upper storage electrode CEs1b may be electrically connected to the twelfth conductive pattern 1730 corresponding to the first node N1.

By forming the storage capacitor Cst with the structure described above, the storage capacitor Cst of the display device according to an embodiment may have a high storage capacity. Specifically, compared to the case where only the first sub-storage capacitor Cst1 is formed using the first conductive layer 1300 (see FIG. 12) and the second conductive layer 1400 (see FIG. 13), in case that the second sub-storage capacitor Cst2 is additionally formed in addition to the first sub-storage capacitor Cst1 by using the second conductive layer 1400 (see FIG. 13) and the oxide semiconductor layer 1500 (see FIG. 14), the capacity of the storage capacitor Cst may be significantly increased while using a same pixel circuit area. Accordingly, the display panel 10 according to an embodiment may maintain a high resolution, reduce the voltage change of the first node N1 (see FIG. 8) by increasing the capacity of the storage capacitor Cst, and drive the pixel circuit PC more stably.

As discussed, embodiments may provide a display panel comprising: a substrate; a pixel circuit layer disposed over the substrate and comprising a first pixel circuit; and a light-emitting diode electrically connected to the first pixel circuit, wherein the pixel circuit layer further comprises: a first conductive layer comprising a first conductive pattern disposed over the substrate; a second conductive layer disposed over the first conductive layer and comprising a second conductive pattern partially overlapping the first conductive pattern; and a first semiconductor layer disposed over the second conductive layer and comprising a first semiconductor pattern overlapping the second conductive pattern, wherein the first semiconductor pattern is conductive.

An insulating layer may be disposed between the first conductive layer and the second conductive layer.

An insulating layer may be disposed between the second conductive layer and the first semiconductor layer.

The first semiconductor pattern may form an electrode (e.g. an upper electrode) of a capacitor in the pixel circuit. The first conductive pattern may form another electrode (e.g. a lower electrode) of this capacitor.

The first semiconductor pattern may be connected to a driving voltage line. The driving voltage line may supply a constant voltage. For example, the driving voltage line may be connected to a constant voltage supply. Each of the first conductive pattern and the first semiconductor pattern may be electrically connected to the driving voltage line.

The first semiconductor pattern may comprise a portion of the first semiconductor layer that has been treated to make it conductive.

The first semiconductor layer may further comprise a second semiconductor pattern, the second semiconductor pattern comprising a channel region of a transistor, wherein the first semiconductor pattern and the second semiconductor pattern are disposed on a same layer. The first semiconductor pattern and the second semiconductor pattern may be disposed to be spaced apart from each other.

The first semiconductor pattern be conductive in its entirety to function as an electrode of a capacitor. For example, this may be achieved by plasma treatment of the first semiconductor pattern.

Specifically, the first semiconductor layer may be an oxide semiconductor layer. These may have a property in which the conductive characteristics change depending on the oxygen content. In particular, a metal oxide semiconductor, such as ITZO or IGZO, may have the characteristics of a conductor or a semiconductor by appropriately controlling the oxygen content. Oxide semiconductor may basically have the characteristics of a semiconductor, but in case that the oxygen content in the oxide semiconductor is reduced, the metallic properties may be strengthened and the oxide semiconductor may have the properties of a conductor. The plasma treatment described above may be used as a method for reducing the oxygen content in the oxide semiconductor. In case that plasma treatment is performed on the first semiconductor layer, the oxygen contained therein may be released and the resistance of the oxide semiconductor may be lowered, and thus, the oxide semiconductor may become conductive. For example, the oxygen content of the conductive first semiconductor pattern may be less than the oxygen content of other portions of the first semiconductor pattern.

For example, the oxygen content of the conductive first semiconductor pattern may be less than the oxygen content of the second semiconductor pattern that may form the channel region of a transistor.

Embodiments may provide an electronic device comprising: a display panel; and a lower cover forming an exterior and having an opening exposing a portion of the display panel to a front surface, wherein the display panel is according to any one of the above mentioned embodiments.

According to some embodiments, a display panel having a high-speed drive or response speed and providing high-quality images, and an electronic device including the display panel may be provided. The aforementioned features and advantages are by way of examples only, and the features and advantages of the disclosure are not limited thereto.

Embodiments have been disclosed herein, and although terms are employed, they are used and are to be interpreted in a generic and descriptive sense only and not for purpose of limitation. In some instances, as would be apparent by one of ordinary skill in the art, features, characteristics, and/or elements described in connection with an embodiment may be used singly or in combination with features, characteristics, and/or elements described in connection with other embodiments unless otherwise specifically indicated. Accordingly, it will be understood by those of ordinary skill in the art that various changes in form and details may be made without departing from the scope of the disclosure as set forth in the following claims.

## Claims

1. A display panel comprising:
a substrate;
a pixel circuit layer disposed over the substrate and comprising a first pixel circuit; and
a light-emitting diode electrically connected to the first pixel circuit,
wherein the pixel circuit layer further comprises:
a first conductive layer comprising a first conductive pattern disposed over the substrate;
a second conductive layer disposed over the first conductive layer and comprising a second conductive pattern partially overlapping the first conductive pattern; and
a first semiconductor layer disposed over the second conductive layer and comprising a first semiconductor pattern overlapping the second conductive pattern,
wherein the first semiconductor pattern is conductive.

2. The display panel of claim 1, wherein the first semiconductor layer comprises an oxide semiconductor material.

3. The display panel of claim 1 or 2, wherein the first semiconductor pattern comprises a portion of the first semiconductor layer that has been treated to make it conductive.

4. The display panel of any one of claims 1 to 3, wherein a constant voltage is applied to the first conductive pattern and the first semiconductor pattern.

5. The display panel of any one of claims 1 to 4, wherein the first pixel circuit comprises:
a first transistor connected between a driving voltage line and the light-emitting diode;
a storage capacitor connected between a first node to which a gate electrode of the first transistor is connected and a second node to which a first electrode of the first transistor is connected; and
a hold capacitor connected to the second node.

6. The display panel of claim 5, wherein
the first semiconductor layer further comprises a second semiconductor pattern, the second semiconductor pattern comprising a channel region of the first transistor, wherein the first semiconductor pattern and the second semiconductor pattern are disposed on a same layer;
the first semiconductor pattern and the second semiconductor pattern are disposed to be spaced apart from each other.

7. The display panel of claim 5 or 6, wherein
the hold capacitor comprises a first sub-hold capacitor and a second sub-hold capacitor that overlap each other;
the first sub-hold capacitor comprises a portion of the second conductive pattern overlapping the first conductive pattern, and
the second sub-hold capacitor comprises a portion of the second conductive pattern overlapping the first semiconductor pattern.

8. The display panel of any one of claims 5 to 7, wherein the hold capacitor is connected between the second node and the driving voltage line.

9. The display panel of any one of claims 5 to 8, wherein the first conductive pattern and the first semiconductor pattern are electrically connected to the driving voltage line and receive a same driving voltage.

10. The display panel of any one of claims 5 to 9, wherein the first pixel circuit further comprises:
a second transistor connected between a data line and the first node; and
a third transistor connected between a reference voltage line and the first node.

11. The display panel of claim 10, wherein
the hold capacitor is connected between the second node and the driving voltage line, and the first pixel circuit further comprises an auxiliary hold capacitor connected between a lower gate electrode of the first transistor and the reference voltage line;
the auxiliary hold capacitor comprises a third sub-hold capacitor and a fourth sub-hold capacitor that overlap each other;
the first conductive layer further comprises a third conductive pattern disposed to be spaced apart from the first conductive pattern,
the first semiconductor layer further comprises a third semiconductor pattern that is disposed to be apart from the first semiconductor pattern and is conductive,
the third sub-hold capacitor comprises a portion of the second conductive pattern overlapping the third conductive pattern, and
the fourth sub-hold capacitor comprises a portion of the second conductive pattern overlapping the third semiconductor pattern.

12. The display panel of any one of claims 5 to 11, wherein
the first conductive layer further comprises a fourth conductive pattern disposed on a same layer as the first conductive pattern and disposed to be apart from the first conductive pattern,
the second conductive pattern extends and partially overlaps the fourth conductive pattern.

13. The display panel of claim 12, wherein
the storage capacitor comprises a first sub-storage capacitor and a second sub-storage capacitor,
the first sub-storage capacitor comprises a portion of the second conductive pattern overlapping the fourth conductive pattern,
the second sub-storage capacitor comprises a portion of the second conductive pattern overlapping the first semiconductor pattern, and
the first semiconductor pattern is electrically connected to an electrode corresponding to the first node.

14. The display panel of any one of claims 5 to 13, wherein
the first pixel circuit further comprises a fourth transistor connected between the driving voltage line and the first transistor,
the pixel circuit layer further comprises a second semiconductor layer comprising a channel region of the fourth transistor,
the second semiconductor layer is disposed between the substrate and the first conductive layer, and
the second semiconductor layer comprises a silicon semiconductor material.

15. An electronic device comprising:
a display panel; and
a lower cover forming an exterior and having an opening exposing a portion of the display panel to a front surface,
wherein the display panel is according to any one of claims 1 to 14.
